# FASCICULE DE BREVET EUROPEEN

(11) **EP 2 960 951 B1**
(45) Date de publication et mention de la délivrance du brevet: **26.02.2020**
(21) Numéro de dépôt: 15173554.5
(22) Date de dépôt: 24.06.2015
(51) Int. Cl.: H01L 31/10, H01L 33/00, H01L 31/0224, H01L 31/0352, H01L 31/113, H01L 31/18, H01L 33/38, H01L 33/14, H01L 27/15

(54) **DISPOSITIF OPTOELECTRONIQUE A JONCTION P-N PERMETTANT UNE IONISATION DE DOPANTS PAR EFFET DE CHAMP**
OPTOELEKTRONISCHE VORRICHTUNG MIT P-N-ÜBERGANG, DIE EINE IONISIERUNG DER DOTIERUNGSMITTEL DURCH FELDEFFEKT ERMÖGLICHT
OPTOELECTRONIC DEVICE WITH P-N JUNCTION ENABLING THE IONISATION OF DOPANTS BY FIELD EFFECT

(30) Priorité: 27.06.2014 FR 1456084
(43) Date de publication de la demande: 30.12.2015
(73) Titulaire: Commissariat à l'Énergie Atomique et aux Énergies Alternatives, 75015 Paris (FR)
(72) Inventeur: Robin, Ivan-Christophe, 38000 Grenoble (FR); Bono, Hubert, 38000 Grenoble (FR)
(74) Mandataire: Brevalex

(56) Documents cités:
- EP-A2- 1 204 184
- WO-A1-2009/128777
- DE-U1-202006 003 360
- FR-A1- 2 992 465
- US-A1- 2013 126 826

## Description

### DOMAINE TECHNIQUE ET ART ANTÉRIEUR

L'invention concerne le domaine des dispositifs optoélectroniques à jonction p-n tels que des diodes électroluminescentes (DELs ou LEDs ou micro-LEDs), utilisées notamment pour la réalisation de tout dispositif lumineux à base de LEDs (écrans, projecteurs, murs d'images, etc.), ou des dispositifs photodétecteurs tels que des photodiodes.

Une diode électroluminescente émettant une lumière bleue comprend généralement une jonction p-i-n à base de GaN comportant : une couche de GaN dopée p à typiquement 10¹⁹ accepteurs/cm³, une couche non intentionnellement dopée, ou intrinsèque, de GaN typiquement à 10¹⁷ donneurs/cm³ dans laquelle sont formés des puits quantiques d'InGaN, et une couche de GaN dopée n à 10¹⁹ donneurs/cm³. La couche non intentionnellement dopée et comprenant les puits quantiques dans lesquels se produit l'émission lumineuse est appelée zone active. Une couche de blocage d'électrons en AIGaN avec une concentration en aluminium comprise entre 8 % et 15 % et dopée p peut être rajoutée entre la zone active et la couche de GaN dopée p, comme décrit dans le document « The influence of acceptor anneal temperature on the performance of InGaN/GaN quantum well light-emitting diodes », J. D. Thomson et al., Journal of Applied Physics 99, 024507 (2006). Cette couche de blocage d'électrons permet de limiter le déplacement des électrons de la zone active vers la couche de GaN dopée p.

Le principal problème limitant l'efficacité de ce type de diode électroluminescente est l'énergie d'activation élevée des accepteurs dans la couche de GaN dopée p, qui est typiquement de l'ordre de 200 meV.

Une diode électroluminescente émettant dans le domaine des UV (LED UV) peut être réalisée en utilisant de l'AlGaN pour former la jonction p-i-n, avec des puits quantiques en GaN. Plus la concentration en aluminium dans l'AlGaN augmente, plus l'énergie d'activation des accepteurs dans l'AlGaN dopé p augmente. A titre d'exemple, cette énergie d'activation est de l'ordre de 600 meV dans l'AlN. La quantité d'accepteurs activés dans l'AlGaN est alors extrêmement faible, limitant d'autant l'efficacité d'une telle LED UV.

Pour réduire l'énergie d'activation des accepteurs dans cette LED UV, du GaN dopé p peut être utilisé à la place de l'AlGaN dopé p. Cela a par contre comme inconvénient de limiter l'efficacité radiative dans la zone active de la LED UV qui est en AIGaN. De plus, une partie de la lumière UV émise par la zone active est absorbée par le GaN dopé p.

Dans les exemples décrits ci-dessus, les limitations observées sont dues à l'énergie d'activation élevée des accepteurs dans la jonction p-n. Il est également possible de rencontrer des problèmes analogues liés à une énergie d'activation élevée des donneurs lorsqu'ils sont profonds. Par exemple, ces problèmes se retrouvent dans le cas de LEDs dont les jonctions p-n sont réalisées en diamant car dans ce cas, les donneurs ont une forte énergie d'ionisation (de l'ordre de 460 meV).

De plus, les problèmes exposés ci-dessus se retrouvent également de manière analogue pour des photodiodes, par exemple celles destinées à réaliser une détection de lumière UV et réalisées à partir d'AIGaN ou de diamant.

Le document DE 20 2006 003360 U1 divulgue un transistor à effet de champ émetteur de lumière ayant une structure mesa placée entre deux électrodes, dans lequel l'injection de porteurs de charge dans la jonction est commandée par une grille formée sur une surface latérale de la jonction, et isolée de la zone de charge d'espace par un isolant diélectrique. Ladite grille permet donc de contrôler l'activation des dopants présents dans les couches semiconductrices.

Le document FR 2 992 465 A1 divulgue un dispositif optoélectronique (en particulier, une DEL) comprenant une première et une deuxième électrode, dont les faces supérieures forment une surface continue sensiblement plane afin d'en faciliter le montage.

### EXPOSÉ DE L'INVENTION

Un but de la présente invention est de proposer un nouveau type de dispositif optoélectronique à jonction p-n, par exemple une diode électroluminescente ou une photodiode, dont l'efficacité d'émission ou de détection, ou efficacité quantique interne, est améliorée par rapport aux dispositifs optoélectroniques à jonction p-n de l'art antérieur, notamment pour des matériaux semi-conducteurs présentant des énergies d'activation d'accepteurs ou de donneurs élevées.

Pour cela, la présente invention propose un dispositif optoélectronique selon la revendication 1, comportant au moins une structure mesa comprenant au moins :
- une première et une deuxième portions de semi-conducteur, l'une étant dopée p et l'autre étant dopée n, et formant ensemble une jonction p-n,
- une première électrode reliée électriquement à la première portion de semi-conducteur qui est disposée entre la deuxième portion de semi-conducteur et la première électrode,
le dispositif optoélectronique comportant en outre au moins :
- une deuxième électrode reliée électriquement à la deuxième portion de semi-conducteur,
- un élément apte à ioniser des dopants de la jonction p-n, ou plus précisément apte à ioniser des dopants de la première et/ou deuxième portion de semi-conducteur, via une génération d'un champ électrique dans la jonction p-n, ou plus précisément dans la première et/ou deuxième portion de semi-conducteur, et recouvrant au moins une partie des flancs latéraux d'au moins une partie de la première et/ou de la deuxième portion de semi-conducteur localisée au niveau de la jonction p-n, ou plus précisément au moins une partie de la première et/ou de la deuxième portion de semi-conducteur et au moins une partie d'une zone de charge d'espace formée par les première et deuxième portions de semi-conducteur,
et dans lequel des faces supérieures d'au moins la première électrode et de la deuxième électrode forment une surface continue sensiblement plane.

La présence de l'élément apte à ioniser des dopants de la jonction p-n, ou apte à ioniser des dopants de la première et/ou deuxième portion de semi-conducteur, à proximité du semi-conducteur dopé p ou n du dispositif optoélectronique permet la génération d'un champ électrique améliorant la conductivité du semi-conducteur dopé p ou n. Cet effet de champ entraîne une ionisation des dopants dans ce semi-conducteur (ionisation des accepteurs pour du semi-conducteur dopé p ou ionisation des donneurs pour du semi-conducteur dopé n), ce qui permet d'augmenter l'efficacité quantique interne, c'est-à-dire l'efficacité d'émission ou de réception, du dispositif optoélectronique car par exemple un plus grand nombre d'accepteurs (trous) sont disponibles pour se recombiner avec les donneurs (électrons) provenant du semi-conducteur dopé n du dispositif notamment lorsque le semi-conducteur dopé p a une énergie d'activation des accepteurs élevée, ou bien un plus grand nombre de donneurs sont disponibles pour se recombiner avec les accepteurs du semi-conducteur dopé p notamment lorsque le semi-conducteur dopé n a une énergie d'activation des donneurs élevée.

Le dispositif optoélectronique peut comporter avantageusement un ou des semi-conducteurs ayant des énergies d'activation d'accepteurs importantes, par exemple supérieures ou égales à environ 50 meV, tels que du GaN (dont la valeur de l'énergie d'ionisation des accepteurs est d'environ 200 meV) et des puits quantiques en InGaN (dont la valeur de l'énergie d'ionisation varie en fonction de la concentration d'indium et est comprise entre environ 50 meV et 200 meV), par exemple pour la réalisation d'une diode électroluminescente émettant une lumière de couleur bleue, ou de l'AlGaN (dont la valeur de l'énergie d'ionisation des accepteurs est supérieure à environ 200 meV), ou de l'AlN (dont la valeur de l'énergie d'ionisation des accepteurs est égale à environ 600 meV), et des puits quantiques en GaN ou en AIGaN, par exemple pour la réalisation d'une diode électroluminescente émettant une lumière UV ou d'une photodiodes réalisant une détection de lumière UV. Il est également possible que l'InGaN soit utilisé en tant que matériau semi-conducteur de type p pour certaines diodes électroluminescentes.

Il est également possible que le dispositif optoélectronique comporte un ou des semi-conducteurs ayant des énergies d'activation de donneurs importantes, par exemple supérieures ou égales à environ 50 meV tel que du diamant (dont la valeur de l'énergie d'ionisation des donneurs est d'environ 460 meV), par exemple pour la réalisation d'une diode électroluminescente ou d'une photodiode fonctionnant dans le domaine UV.

Un dispositif optoélectronique selon l'invention comprend une première portion de semi-conducteur, la première portion de semi-conducteur étant dopée p et comportant au moins un semi-conducteur dont une énergie d'activation des accepteurs est supérieure ou égale à environ 200 meV, ou la première portion de semi-conducteur étant dopée n et comportant au moins un semi-conducteur dont une énergie d'activation des donneurs est supérieure ou égale à environ 200 meV. Un dispositif ne satisfaisant pas cette condition ne fait pas partie de l'invention telle que revendiquée.

La forte intégration des éléments d'un tel dispositif optoélectronique a pour avantage de minimiser les densités de courant obtenues dans les électrodes, et donc de réduire l'échauffement par effet Joule au sein du dispositif.

L'expression « structure mesa » désigne le fait que le dispositif optoélectronique est réalisé sous la forme d'un empilement de la première et de la deuxième portions de semi-conducteur dopées, une zone de jonction étant présente entre ces deux portions de semi-conducteur dopées, et que cet empilement est gravé sur au moins une partie de sa hauteur sous forme d'îlot appelé mesa et pouvant former des plots de toute forme comportant un tel empilement.

De plus, la surface continue sensiblement plane formée par au moins les faces supérieures des électrodes du dispositif permet d'hybrider facilement, par exemple sans faire appel à des inserts tels que des microbilles de connexion, le dispositif à un autre élément, tel qu'un circuit électronique pouvant comporter également une face plane au niveau de laquelle se trouve des matériaux analogues à ceux du dispositif, par exemple par collage direct.

Les faces supérieures des électrodes forment une surface continue sensiblement plane, c'est-à-dire sont disposées sensiblement dans un même plan. L'expression « sensiblement plane » est ici utilisée pour désigner le fait que la surface formée par ces faces supérieures peut présenter des variations de hauteur, ou d'épaisseur, comprises entre 0 et environ 150 nm.

Le terme « jonction p-n » utilisé ici désigne également une jonction de type p-i-n.

La zone de charge d'espace, ou zone de déplétion, correspond à la région qui apparait dans la jonction P-N, entre la portion dopée N et la portion dopée P et qui est dépourvue de porteurs libres.

L'élément apte à ioniser des dopants de la jonction p-n peut comporter :
- au moins une couche de passivation diélectrique recouvrant ladite au moins une partie des flancs latéraux d'au moins une partie de la première et/ou de la deuxième portion de semi-conducteur localisée au niveau de la jonction p-n et au moins une grille électriquement conductrice telle que la couche de passivation diélectrique soit disposée entre la grille et ladite au moins une partie de la première et/ou de la deuxième portion de semi-conducteur, et/ou
- au moins une portion métallique recouvrant ladite au moins une partie des flancs latéraux d'au moins une partie de la première et/ou de la deuxième portion de semi-conducteur localisée au niveau de la jonction p-n et formant un contact Schottky avec ladite au moins une partie de la première et/ou de la deuxième portion de semi-conducteur.

L'élément apte à ioniser des dopants de la première et/ou deuxième portion de semi-conducteur peut comporter :
- au moins une couche de passivation diélectrique recouvrant ladite au moins une partie des flancs latéraux d'au moins une partie de la première et/ou de la deuxième portion de semi-conducteur et d'au moins une partie de la zone de charge d'espace, et au moins une grille électriquement conductrice telle que la couche de passivation diélectrique soit disposée entre la grille et ladite au moins une partie de la première et/ou de la deuxième portion de semi-conducteur et entre la grille et ladite au moins une partie de la zone de charge d'espace, et/ou
- au moins une portion métallique recouvrant ladite au moins une partie des flancs latéraux d'au moins une partie de la première et/ou de la deuxième portion de semi-conducteur et d'au moins une partie de la zone de charge d'espace et formant un contact Schottky avec ladite au moins une partie de la première et/ou de la deuxième portion de semi-conducteur et avec ladite au moins une partie de la zone de charge d'espace.

Dans ce cas, le dispositif optoélectronique peut être tel que :
- une première partie de la couche de passivation diélectrique entoure latéralement au moins en partie la première électrode, la première portion de semi-conducteur et au moins une partie de la deuxième portion de semi-conducteur,
- la grille recouvre latéralement la première partie de la couche de passivation diélectrique,
- une deuxième partie de la couche de passivation diélectrique recouvre latéralement la grille (la grille pouvant être disposée entre la première et la deuxième parties de la couche de passivation diélectrique), et
- la deuxième électrode recouvre latéralement la deuxième partie de la couche de passivation diélectrique,
ou le dispositif optoélectronique peut être tel que :
- la portion métallique entoure latéralement au moins en partie la première électrode, la première portion de semi-conducteur et au moins une partie de la deuxième portion de semi-conducteur, et
- la deuxième électrode recouvre latéralement la portion métallique.

Dans ce cas, la surface continue sensiblement plane peut être formée par les faces supérieures des électrodes, de la grille et de la couche de passivation diélectrique, ou bien par les faces supérieures des électrodes et de la portion métallique. Des légères variations de hauteur ou d'épaisseur peuvent avoir pour origine la mise en œuvre d'une planarisation mécano-chimique (CMP) mise en œuvre en présence des matériaux des électrodes, de la grille et de la couche de passivation diélectrique, les vitesses de gravure des matériaux conducteurs des électrodes (et éventuellement de la grille lorsque celle-ci est exposée au niveau de la face supérieure du dispositif) étant différentes par rapport à celle du matériau diélectrique de la couche de passivation. Ces légères variations de hauteur ou d'épaisseur, entre les faces supérieures de la couche de passivation diélectrique et celles des électrodes, peuvent avoir pour avantage de garantir une excellente isolation entre les électrodes du dispositif et/ou vis-à-vis de la grille et/ou d'électrodes ou de grilles de diodes adjacentes lorsque des creux se situent au niveau des faces supérieures des électrodes et/ou de la grille.

Le dispositif optoélectronique peut comporter :
- plusieurs structures mesa,
- plusieurs couches de passivation diélectriques recouvrant chacune au moins une partie des flancs latéraux d'au moins une partie de la première et/ou de la deuxième portion de semi-conducteur localisée au niveau de la jonction p-n d'une des structures mesa, c'est-à-dire au moins une partie des flancs latéraux d'au moins une partie de la première et/ou de la deuxième portion de semi-conducteur et d'au moins une partie de la zone de charge d'espace d'une des structures mesa, et plusieurs grilles électriquement conductrices telles que chaque couche de passivation diélectrique est disposée entre l'une des grilles et ladite au moins une partie de la première et/ou de la deuxième portion de semi-conducteur d'une des structures mesa et entre l'une des grilles et ladite au moins une partie de la zone de charge d'espace d'une des structures mesa, ou plusieurs portions métalliques recouvrant chacune au moins une partie des flancs latéraux d'au moins une partie de la première et/ou de la deuxième portion de semi-conducteur localisée au niveau de la jonction p-n d'une des structures mesa, c'est-à-dire au moins une partie des flancs latéraux d'au moins une partie de la première et/ou de la deuxième portion de semi-conducteur et d'au moins une partie de la zone de charge d'espace d'une des structures mesa,
et la deuxième électrode peut être reliée électriquement à la deuxième portion de semi-conducteur de chacune des structures mesa, et les faces supérieures d'au moins la première électrode de chacune des structures mesa et de la deuxième électrode peuvent former la surface continue sensiblement plane.

Dans ce cas :
- chacune des structures mesa peut être entourée latéralement au moins en partie par une première partie d'une des couches de passivation diélectriques,
- chacune des grilles peut recouvrir latéralement la première partie d'une des couches de passivation diélectriques,
- une deuxième partie de chacune des couches de passivation diélectriques peut recouvrir latéralement l'une des grilles (qui est donc disposée entre la première et la deuxième partie d'une des couches de passivation diélectriques), et
- la deuxième électrode peut recouvrir latéralement les deuxièmes parties des couches de passivation diélectriques,
ou bien :
- chacune des structures mesa peut être entourée latéralement au moins en partie par une des portions métalliques, et
- la deuxième électrode peut recouvrir latéralement les portions métalliques.

En variante :
- la grille peut comporter au moins une portion d'au moins un matériau électriquement conducteur s'étendant dans la structure mesa, ou la portion métallique peut s'étendre dans la structure mesa, et
- la deuxième électrode peut être disposée autour de la structure mesa.

Le dispositif optoélectronique peut comporter plusieurs structures mesa, et :
- la grille peut comporter plusieurs portions d'au moins un matériau électriquement conducteur s'étendant dans une ou plusieurs des structures mesa, ou plusieurs portions métalliques peuvent s'étendre dans une ou plusieurs des structures mesa, et
- la deuxième électrode peut être disposée autour de la ou de chacune des structures mesa.

Le dispositif optoélectronique peut comporter en outre un contact électrique disposé à côté de la ou des structures mesa et de la deuxième électrode, et auquel la ou les grilles ou la ou les portions métalliques sont reliées électriquement.

La surface continue sensiblement plane peut être formée en outre par une ou des faces supérieures de la ou des grilles ou de la ou des portions métalliques, et/ou par des faces supérieures de la ou des couches de passivation diélectriques, et/ou la ou chacune des couches de passivation diélectriques peut recouvrir une face supérieure de la ou de chacune des grilles.

La couche de passivation diélectrique peut recouvrir une face supérieure de la grille.

Le dispositif optoélectronique peut comporter en outre au moins une couche tampon comportant un semi-conducteur dopé selon le même type de conductivité que la deuxième portion de semi-conducteur et sur laquelle sont disposées la deuxième portion de semi-conducteur et la deuxième électrode l'une à côté de l'autre.

Le dispositif optoélectronique peut comporter en outre une deuxième couche de semi-conducteur dopée comportant une face supérieure structurée dont une première partie saillante forme la deuxième portion de semi-conducteur, et la deuxième électrode peut être disposée sur au moins une deuxième partie de la deuxième couche de semi-conducteur dopée formant un creux de la face structurée de la deuxième couche de semi-conducteur dopée.

En variante, une première partie de la deuxième portion de semi-conducteur disposée entre une deuxième partie de la deuxième portion de semi-conducteur et la première portion de semi-conducteur peut former un décrochement par rapport à la deuxième partie de la deuxième portion de semi-conducteur, et la deuxième électrode peut être reliée électriquement à la deuxième portion de semi-conducteur au niveau d'une face supérieure de la deuxième partie de la deuxième portion de semi-conducteur.

La première portion de semi-conducteur est dopée p et comporte au moins un semi-conducteur dont une énergie d'activation des accepteurs est supérieure ou égale à environ 200 meV, ou la première portion de semi-conducteur est dopée n et comporte au moins un semi-conducteur dont une énergie d'activation des donneurs est supérieure ou égale à environ 200 meV.

L'invention concerne également un dispositif électronique comportant un ou plusieurs dispositifs optoélectroniques tels que décrits ci-dessus et correspondant à une ou plusieurs diodes électroluminescentes et/ou une ou plusieurs photodiodes.

L'invention concerne également un procédé d'émission lumineuse à partir d'un dispositif optoélectronique tel que décrit ci-dessus, comportant la mise en œuvre d'une polarisation du dispositif optoélectronique par l'application d'une tension électrique entre la ou les premières électrodes et la deuxième électrode du dispositif optoélectronique, et :
- l'application d'une différence de potentiels électriques entre la ou les grilles ou portions métalliques et la ou les électrodes reliées électriquement à la ou aux portions de semi-conducteur dopées p telle que le potentiel électrique appliqué sur la ou les grilles ou portions métalliques est inférieur ou égal au potentiel électrique appliqué sur la ou les électrodes reliées électriquement à la ou aux portions de semi-conducteur dopées p, ou
- l'application d'une différence de potentiels électriques entre la ou les grilles ou portions métalliques et la ou les électrodes reliées électriquement à la ou aux portions de semi-conducteur dopées n telle que le potentiel électrique appliqué sur la ou les grilles ou portions métalliques est supérieur ou égal au potentiel électrique appliqué sur la ou les électrodes reliées électriquement à la ou aux portions de semi-conducteur dopées n.

L'invention concerne également un procédé de conversion photoélectrique à partir d'un dispositif optoélectronique tel que décrit ci-dessus, comportant :
- l'application d'une différence de potentiels électriques entre la ou les grilles ou portions métalliques et la ou les électrodes reliées électriquement à la ou aux portions de semi-conducteur dopées p telle que le potentiel électrique appliqué sur la ou les grilles ou portions métalliques est inférieur ou égal au potentiel électrique appliqué sur la ou les électrodes reliées électriquement à la ou aux portions de semi-conducteur dopées p, ou
- l'application d'une différence de potentiels électriques entre la ou les grilles ou portions métalliques et la ou les électrodes reliées électriquement à la ou aux portions de semi-conducteur dopées n telle que le potentiel électrique appliqué sur la ou les grilles ou portions métalliques est supérieur ou égal au potentiel électrique appliqué sur la ou les électrodes reliées électriquement à la ou aux portions de semi-conducteur dopées n.

L'invention concerne également un procédé de réalisation d'un dispositif optoélectronique selon la revendication 16, comportant au moins les étapes de :
- réalisation d'un empilement de couches comprenant au moins une première couche de semi-conducteur disposée entre une deuxième couche de semi-conducteur et une couche électriquement conductrice, l'une de la première et de la deuxième couche de semi-conducteur étant dopée p et l'autre de la première et de la deuxième couche de semi-conducteur étant dopée n,
- gravure de l'empilement de couches, réalisant au moins une structure mesa comprenant une première et une deuxième portions de semi-conducteur formant une jonction p-n et une première électrode reliée électriquement à la première portion de semi-conducteur,
- réalisation d'un élément apte à ioniser des dopants de la jonction p-n, ou apte à ioniser des dopants de la première et/ou deuxième portion de semi-conducteur, via une génération d'un champ électrique dans la jonction p-n, ou dans la première et/ou deuxième portion de semi-conducteur et recouvrant au moins une partie des flancs latéraux d'au moins une partie de la première et/ou de la deuxième portion de semi-conducteur localisée au niveau de la jonction p-n, c'est-à-dire au moins une partie des flancs latéraux d'au moins une partie de la première et/ou de la deuxième portion de semi-conducteur et d'au moins une partie d'une zone de charge d'espace formée par les première et deuxième portions de semi-conducteur,
- réalisation d'une deuxième électrode reliée électriquement à la deuxième portion de semi-conducteur,
et dans lequel au moins la réalisation de la deuxième électrode comporte une étape de planarisation d'un matériau électriquement conducteur telle que des faces supérieures d'au moins la première électrode et la deuxième électrode forment une surface continue sensiblement plane.

Un tel procédé a pour avantage, en plus de ceux obtenus grâce à la présence de l'élément apte à ioniser des dopants de la jonction p-n, de nécessiter un nombre limité d'étapes pour sa mise en œuvre.

Il est également décrit un procédé de réalisation d'un dispositif électronique, comportant la mise en œuvre d'un procédé de réalisation d'au moins un dispositif optoélectronique tel que décrit ci-dessus.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement un dispositif optoélectronique, objet de la présente invention, selon un premier mode de réalisation ;
- la figure 2 représente schématiquement le phénomène de courbure de bandes se produisant dans une diode électroluminescente selon l'invention ;
- les figures 3 à 9 représentent l'efficacité quantique interne obtenue en fonction de la densité de courant dans différentes diodes électroluminescentes, objets de la présente invention, pour différentes valeurs d'une différence de potentiels entre la grille et l'anode de ces diodes électroluminescentes ;
- les figures 10 et 11 représentent schématiquement un dispositif optoélectronique, objet de la présente invention, selon un deuxième mode de réalisation ;
- la figure 12 représente schématiquement un dispositif optoélectronique, objet de la présente invention, selon une variante du deuxième mode de réalisation ;
- les figures 13 et 14 représentent schématiquement un dispositif optoélectronique, objet de la présente invention, selon un troisième mode de réalisation ;
- la figure 15 représente schématiquement un dispositif optoélectronique, objet de la présente invention, selon une variante du troisième mode de réalisation ;
- les figures 16A à 16L représentent schématiquement des étapes d'un procédé de réalisation d'un dispositif optoélectronique, objet de la présente invention, selon le deuxième mode de réalisation ;
- les figures 17A à 17F représentent schématiquement des étapes d'un procédé de réalisation d'un dispositif optoélectronique, objet de la présente invention, selon le troisième mode de réalisation ;
- la figure 18 représente schématiquement un dispositif optoélectronique, objet de la présente invention, selon une variante de réalisation ;
- la figure 19 représente schématiquement un dispositif électronique, objet de la présente invention, comportant plusieurs dispositifs optoélectroniques, également objets de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

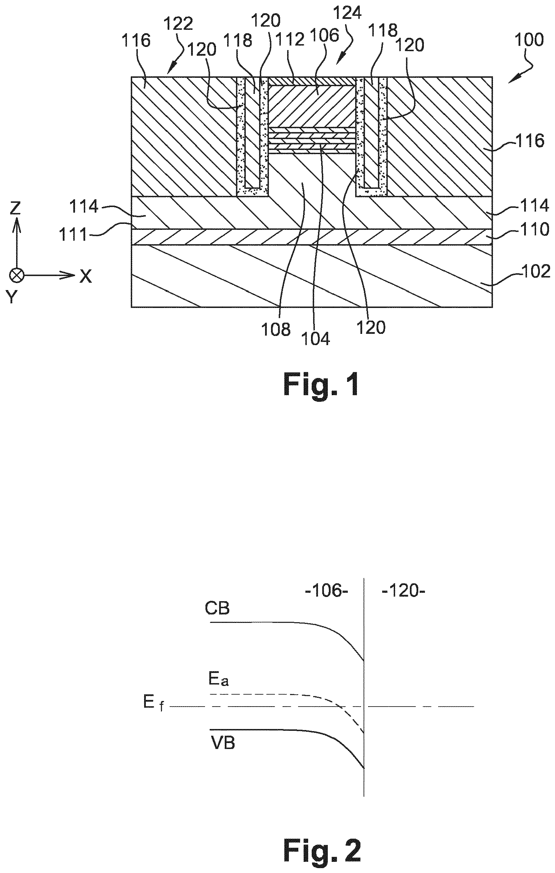

La figure 1 représente schématiquement un dispositif optoélectronique 100 selon un premier mode de réalisation. Dans ce premier mode de réalisation, le dispositif optoélectronique 100 correspond à une diode électroluminescente, ou LED.

La LED 100 comporte un substrat 102, par exemple à base de saphir, destiné à servir de support pour la croissance des autres couches de la LED 100.

La LED 100 comporte une zone active 104 comportant une ou plusieurs couches émissives formant chacune un puits quantique, comportant par exemple de l'InGaN, et étant chacune disposée entre deux couches barrières, comportant par exemple du GaN. L'InGaN comporte par exemple 16 % d'indium. Toutes les couches de la zone active 104, c'est-à-dire la ou les couches émissives et les couches barrières, comportent des matériaux semi-conducteurs intrinsèques, c'est-à-dire non intentionnellement dopés (de concentration en donneurs résiduels n_{nid} par exemple égale à environ 10¹⁷ donneurs/cm³, ou comprise entre environ 10¹⁵ et 10¹⁸ donneurs/cm³). L'épaisseur de la ou de chacune des couches émissives est par exemple égale à environ 2 nm et plus généralement comprise entre environ 0,5 nm et 10 nm, et l'épaisseur de chacune des couches barrières est par exemple égale à environ 5 nm ou comprise entre environ 1 nm et 25 nm. La zone de charge d'espace est principalement située dans cette zone active 104.

La zone active 104 est disposée entre une première portion de semi-conducteur 106 qui est dopée p, et une deuxième portion de semi-conducteur 108 qui est dopée n, les deux portions de semi-conducteur 106 et 108 formant la jonction p-n de la LED 100 (ou plus précisément la jonction p-i-n en considérant la zone active 104). Les portions de semi-conducteur 106 et 108 comportent par exemple du GaN. La première portion 106 est dopée p avec une concentration d'accepteurs (trous) par exemple comprise entre environ 10¹⁷ et 5.10¹⁹ accepteurs/cm³, et ici égale à 10¹⁷ accepteurs/cm³. La deuxième portion 108 est dopée n avec une concentration de donneurs (électrons) par exemple comprise entre environ 10¹⁷ et 5.10¹⁹ donneurs/cm³, et ici égale à 10¹⁷ donneurs/cm³. Les deux portions de semi-conducteur 108 et 106 ont par exemple chacune une épaisseur comprise entre environ 20 nm et 10 µm. Dans l'exemple décrit ici, la première portion de semi-conducteur 106 a une épaisseur égale à environ 500 nm, et la deuxième portion de semi-conducteur 108 a une épaisseur égale à environ 100 nm. La deuxième portion de semi-conducteur 108 est disposée sur une couche tampon 110, comportant par exemple du GaN dopé n avec une concentration par exemple égale à environ 10¹⁹ donneurs/cm³, et d'épaisseur égale à environ 2 µm. La couche tampon 110 comporte généralement le même semi-conducteur et est dopée du même type que la deuxième portion 108.

Des matériaux semi-conducteurs autres que le GaN et l'InGaN peuvent être utilisés pour réaliser la LED 100, notamment selon la gamme de longueurs d'ondes destinées à être émises par la LED 100.

La LED 100 comporte également une première portion de matériau électriquement conducteur, ici métallique, disposée sur la première portion de semi-conducteur 106 et reliée électriquement à celle-ci, formant ainsi une première électrode 112, ici une anode, de la LED 100.

La LED 100 est réalisée en mettant en œuvre une gravure d'un empilement des différentes couches servant à former les éléments de la LED 100 décrits ci-dessus. Dans ce premier mode de réalisation, la deuxième couche de semi-conducteur 111 formant la deuxième portion de semi-conducteur 108 n'est toutefois pas gravée sur toute son épaisseur afin de conserver des parties 114 de cette deuxième couche de semi-conducteur 111 adjacentes à la deuxième portion de semi-conducteur 108 afin que ces parties 114 de semi-conducteur dopée n soient reliées électriquement à une deuxième électrode 116 de la LED 100, qui correspond ici à la cathode du fait que la deuxième portion 108 est dopée n. La deuxième électrode 116 comporte par exemple une couche de titane d'épaisseur égale à environ 20 nm recouverte par une couche d'aluminium.

La deuxième couche de semi-conducteur 111 formant la deuxième portion de semi-conducteur 108 et les parties 114 peut être vue comme comportant une face supérieure structurée dont une première partie saillante forme la deuxième portion de semi-conducteur 108, la deuxième électrode 116 étant disposée sur les deuxièmes parties 114 de la deuxième couche de semi-conducteur 111 formant des creux de la face structurée de cette couche. En variante, la deuxième portion de semi-conducteur 108 et les parties 114 peuvent être réalisées à partir de deux couches distinctes de semi-conducteur superposées l'une au-dessus de l'autre. Dans ce cas, la couche de semi-conducteur servant à former la deuxième portion 108 est gravée sur toute son épaisseur, et celle formant les parties 114 n'est pas gravée (ou peut l'être en partie).

La première électrode 112, la première portion de semi-conducteur 106, la zone active 104 et la deuxième portion de semi-conducteur 108 de la LED 100 forment une structure mesa 124, c'est-à-dire un empilement sous forme d'îlot, disposée sur le substrat 104 (et sur la couche tampon 110). La structure mesa 124 de la LED 100 a une section, dans un plan parallèle à la face du substrat 102 sur laquelle repose cette structure (plan parallèle au plan (X,Y) représenté sur la figure 1), en forme de disque ou de forme rectangulaire ou d'une toute autre forme, polygonale ou non. La structure mesa 124 peut donc former un îlot, ou plot, de forme cylindrique, parallélépipédique, etc. La structure mesa 124 peut également avoir une forme allongée, rectiligne ou non, ou une toute autre forme adaptée à la réalisation d'une diode électroluminescente.

La structure mesa 124 de la LED 100 est entourée par une grille 118 électriquement conductrice. La grille 118 est formée d'un ou plusieurs matériaux électriquement conducteurs, par exemple un ou plusieurs métaux tels que de l'aluminium. L'épaisseur de la grille 118 (dimension selon l'axe X représenté sur la figure 1, c'est-à-dire la dimension perpendiculaire aux flancs latéraux de la structure mesa 124) est par exemple égale à environ 100 nm, ou comprise entre environ 3 nm et 10 µm. Cette grille 118 est isolée électriquement de la jonction p-i-n de la LED 100 (c'est-à-dire des éléments 104, 106 et 108) ainsi que des électrodes 112 et 116 et des parties de semi-conducteur dopées n 114 par une couche de passivation diélectrique 120 comportant par exemple du SiN et une épaisseur égale à environ 10 nm. La grille 118 qui entoure la structure mesa 124 de la LED 100 est elle-même entourée par la deuxième électrode 116. Une première partie de la couche de passivation diélectrique 120 est disposée entre les flancs latéraux de la structure mesa 124 et la grille 118, et une deuxième partie de la couche de passivation diélectrique 120 est disposée entre la grille 118 et la deuxième électrode 116. Excepté la face supérieure de la grille 118, les autres faces de la grille 118 sont en contact avec la couche de passivation diélectrique 120.

Etant donné la structure mesa 124 de la LED 100 et la géométrie de la deuxième électrode 116, de la grille 118 et de la couche de passivation diélectrique 120, les faces supérieures (se trouvant au sommet de la LED 100) de la première électrode 112, de la couche de passivation diélectrique 120, de la grille 118 et de la deuxième électrode 116 forment ensemble une surface 122 sensiblement plane, c'est-à-dire sont disposées sensiblement dans un même plan. Etant donné une étape de planarisation du matériau électriquement conducteur de la deuxième électrode 116 mise en œuvre lors de la réalisation de la LED 100 (étape décrite plus loin en liaison avec le procédé de réalisation), les faces supérieures de la première électrode 112, de la grille 118 et de la deuxième électrode 116 peuvent éventuellement présenter des creux de profondeur (par rapport aux faces supérieures de la couche de passivation diélectrique 120) comprise entre 0 (absence de creux) et environ 150 nm. Cette surface 122 sensiblement plane est bien adaptée pour être hybridée directement à un autre élément, par exemple un circuit électronique comportant des contacts électriques destinés à être solidarisés, par exemple par collage direct métal-métal, à l'anode et à la cathode de la LED 100, et des zones diélectriques destinées à être solidarisées, également par collage direct diélectrique-diélectrique, notamment à la couche de passivation diélectrique 120.

Le principe de fonctionnement d'une telle LED 100 qui, par rapport à une LED classique, diffère notamment en raison de la présence de la grille 118 autour de la structure mesa 124, est décrit ci-dessous.

La grille 118 disposée autour de la jonction de la LED 100 permet de créer un effet de champ contrôlant la ionisation des dopants dans la jonction. En effet, le champ électrique généré par la grille 118 disposée autour de la jonction de la LED 100 permet de ioniser les accepteurs de la première portion de semi-conducteur 106 qui est dopée p et d'augmenter l'efficacité de recombinaison en injectant plus de trous dans la zone active 104.

La grille 118 est disposée autour d'au moins une partie de la première portion de semi-conducteur 106 qui est localisée à proximité de la jonction de la LED 100, c'est-à-dire au moins la partie de la première portion 106 en contact avec la zone active 104 sur l'exemple de la figure 1, de manière à ioniser les accepteurs par effet de champ à la surface de la grille au moins au niveau de cette partie de la première portion 106.

Pour créer le champ électrique, une différence de potentiels est appliquée entre la première électrode 112, formant l'anode de la LED 100, et la grille 118 de la LED 100, ce qui génère un champ électrique. Dans le cas d'un transistor à effet de champ, le champ électrique généré par la grille permet d'inverser le type de conductivité d'une zone et de créer un canal de conduction. Ici, le champ électrique n'inverse pas la conductivité de la première portion de semi-conducteur 106 dopée p, mais exalte sa conductivité. En effet, la quantité d'accepteurs ionisés est fixée par la position du niveau des accepteurs par rapport au niveau de Fermi. Le fait de changer le potentiel de surface courbe les bandes du matériau de la deuxième portion 106. Le niveau des accepteurs est fixe par rapport à la bande de valence. En particulier, si le potentiel de surface est réduit en appliquant sur la grille 118 un potentiel électrique inférieur à celui appliqué sur l'anode 112, cela courbe les bandes vers les énergies négatives de sorte que proche de la surface, le niveau des accepteurs dans la première portion de matériau semi-conducteur dopée p 106 peut passer (mais pas nécessairement) sous le niveau de fermi. Proche de la surface, la totalité des accepteurs sont alors ionisés. Cette courbures des bandes de valence VB, de conduction CB, et de l'énergie des accepteurs Ea par rapport au niveau de Fermi Ef est représentée schématiquement sur la figure 2 au niveau de l'interface entre la première portion de semi-conducteur dopée p 106 et la couche de passivation diélectrique 120 lorsque le potentiel électrique appliqué sur la grille 118 est inférieur à celui appliqué sur l'anode 112.

Plus la différence entre les potentiels appliqués sur la grille 118 et sur l'anode 112 est importante, plus les accepteurs sont ionisés en profondeur. Les accepteurs ionisés libèrent des trous qui peuvent se recombiner dans la zone active 104 avec les électrons provenant de la deuxième portion de semi-conducteur dopée n 108 et créer des photons. Le fait de ioniser en surface les accepteurs par effet de champ augmente donc l'efficacité quantique interne de la LED 100 car plus de trous sont disponibles pour se recombiner avec les électrons provenant de la région de semi-conducteur dopée n.

Le diamètre de la structure mesa 124, ou la dimension des côtés de la structure mesa 124 perpendiculaires à la grille 118, est de préférence inférieur ou égal à environ 50 µm lorsque la structure mesa 124 comporte du GaN, du fait que la zone d'influence de la grille 118, c'est-à-dire la distance jusqu'à laquelle la grille 118 peut ioniser des accepteurs dans le semi-conducteur dopé p de la première portion 106, est de cet ordre. Lorsque de l'AlGaN est utilisé, par exemple dans le cas d'une zone active 104 en GaN ou en AIGaN avec des puits quantiques en AIGaN (avec dans ce cas une concentration en aluminium inférieure à celle dans les couches barrières) ou en GaN, nécessitant dans ce cas des énergies d'ionisation plus importantes des accepteurs et donc un besoin d'un champ électrique plus fort, le diamètre, ou la dimension des côtés entourés par la grille 118, de la structure mesa 124 de la LED 100 est de préférence inférieur ou égal à environ 5 µm. Dans tous les cas, il est avantageux que le diamètre, ou la dimension des côtés entourés par la grille 118, de la structure mesa 124 de la LED 100, soit inférieur ou égal à environ 5 µm.

Des simulations de l'efficacité quantique interne de la LED 100 réalisées avec le logiciel Silvaco d'Atlas sont décrites ci-dessous.

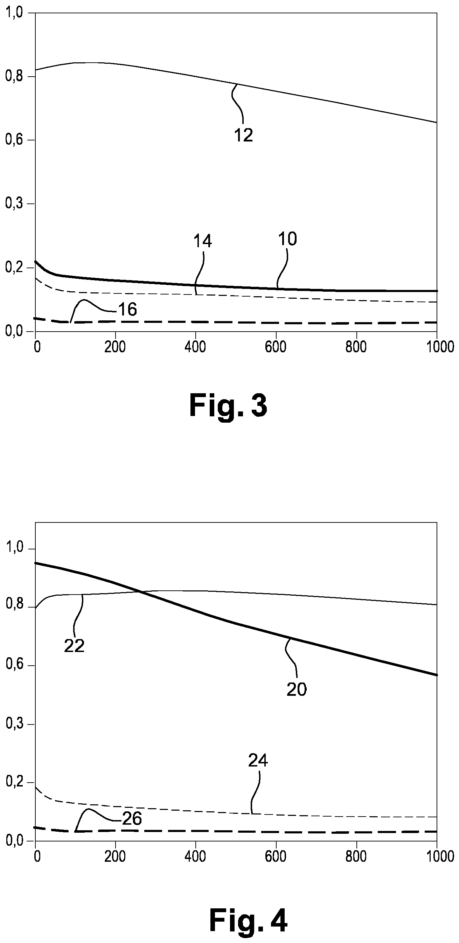

La figure 3 représente l'efficacité quantique interne obtenue dans une LED de structure mesa et comportant une grille entourant la portion de semi-conducteur dopée p, en fonction de la densité de courant, en A/cm², dans la LED pour différentes valeurs d'une différence de potentiels Vg appliquée entre la grille et l'anode (Vg = V_{grille} - V_{anode}). La LED utilisée pour cette simulation comporte plusieurs différences structurelles par rapport à la LED 100 décrite en liaison avec la figure 1 :
- la LED simulée ne comporte pas les parties 114 et la cathode 116 n'est pas disposée autour de la grille 118 mais est disposée sous la deuxième portion de semi-conducteur 108 dopée n, directement en contact avec elle ;
- la zone active 104 de la LED simulée est formée d'un seul puits quantique d'InGaN comportant 16% d'indium et réalisé dans une couche de GaN non intentionnellement dopée (des résultats analogues à ceux décrits ci-dessous seraient toutefois obtenus si la zone active 104 était formée par des éléments différents) ;
- les portions de semi-conducteur dopées p 106 et n 108, la zone active 104 et les électrodes 112 et 116 sont réalisées sous la forme d'une structure mesa cylindrique de diamètre égal à 1 µm ;
- la grille 118 n'est pas réalisée sur toute la hauteur de la jonction de la LED mais est formée uniquement autour de la portion de semi-conducteur dopée p 106, et est séparée de cette portion de semi-conducteur dopée p 106 par une couche de passivation diélectrique 120 en SiO₂ d'épaisseur égale à 5 nm.

La courbe 10 représente l'efficacité quantique interne obtenue dans une telle LED lorsque Vg = 0V. La courbe 12 représente l'efficacité quantique interne obtenue dans une telle LED lorsque Vg = -10V. A titre de comparaison, la courbe 14 représente l'efficacité quantique interne obtenue dans une LED similaire mais ne comportant de grille formée autour de la jonction de la LED. De plus, la courbe 16 représente l'efficacité quantique interne obtenue dans une telle LED lorsque Vg = 10V.

En appliquant une tension Vg = -10V, l'efficacité quantique interne dans la zone active 104 est grandement exaltée : elle passe de 20 % environ lorsque Vg = 0V à plus de 80 % au maximum. Par contre, quand une tension Vg positive est appliquée, l'efficacité quantique interne devient quasi nulle en raison d'une courbure particulière des bandes à l'interface rendant l'ionisation des accepteurs encore plus difficile.

Ces courbes illustrent bien l'augmentation de l'efficacité quantique interne obtenue en appliquant une tension Vg négative entre la grille 118 et l'anode 112 de la LED 100. Cette augmentation de l'efficacité quantique interne de la LED est également obtenue lorsque le potentiel électrique appliqué sur la grille 118 est nul par rapport à une LED similaire ne comportant pas de grille. Ceci est dû au fait que lorsqu'une tension est appliquée entre l'anode 112 et la cathode 116 de la LED, en maintenant la cathode à 0V et en appliquant une tension positive à l'anode 112 pour faire circuler un courant, il existe alors une différence de potentiel entre le semi-conducteur dopé p de la jonction et la grille 118. Ceci crée un effet de champ favorisant l'ionisation des accepteurs dans le semi-conducteur dopé p.

La figure 4 représente l'efficacité quantique interne obtenue dans une LED de structure mesa et comportant une grille 118 entourant la portion de semi-conducteur dopée p 106, en fonction de la densité de courant, en A/cm², dans la LED pour différentes valeurs d'une différence de potentiels entre la grille 118 et l'anode 112. Par rapport à la LED utilisée pour la précédente simulation dont l'efficacité quantique interne obtenue est représentée sur la figure 3, la LED utilisée ici comporte une grille 118 disposée autour de toute la jonction, sur toute la hauteur de la jonction, c'est-à-dire autour des portions de semi-conducteurs dopées n 108 et p 106, et de la zone active 104.

La courbe 20 représente l'efficacité quantique interne obtenue dans une telle LED lorsque Vg = 0V. La courbe 22 représente l'efficacité quantique interne obtenue dans une telle LED lorsque Vg = -10V. La courbe 24 représente l'efficacité quantique interne obtenue dans une LED similaire mais ne comportant de grille formée autour de la jonction de la LED. La courbe 26 représente l'efficacité quantique interne obtenue dans une telle LED lorsque Vg = 10V.

Comme précédemment, l'efficacité quantique interne est grandement exaltée lorsqu'une tension Vg négative ou nulle est appliquée, c'est-à-dire lorsque la différence de potentiels entre la grille et l'anode est nulle ou négative. On voit également sur cette figure que pour une LED dont la grille entoure la jonction sur toute la hauteur de la jonction, pour de faibles densités de courant, par exemple inférieures à environ 250 A/cm², il est même plus intéressant de travailler avec une tension Vg nulle. Ceci est dû au fait que dans cette géométrie-là, la grille a aussi un effet sur l'ionisation des donneurs dans le semi-conducteur dopée n de la LED. Pour une tension de grille nulle, l'effet de champ est faible côté n et ne limite quasiment pas l'ionisation des donneurs. Par contre, du fait de la différence de potentiels entre l'anode et la cathode (environ 3,5 V), un effet de champ déjà conséquent existe côté p. La différence de potentiels entre le semi-conducteur dopé p et la grille permet d'ioniser les accepteurs en surface du semi-conducteur dopé p.

Pour de plus fortes densités de courant, par exemple supérieures à environ 400 A/cm², ce qui limite l'efficacité quantique interne dans le cas où une tension Vg de 0V est appliquée est la quantité limitée d'accepteurs ionisés. Il est dans ce cas préférable d'utiliser une tension Vg négative, par exemple égale à environ -10 V.

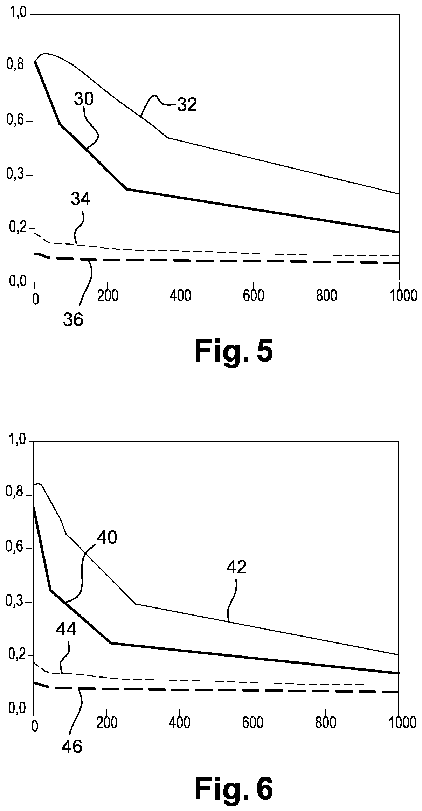

Les figures 5 et 6 représentent l'efficacité quantique interne obtenue dans une LED de structure mesa et comportant une grille entourant la portion de semi-conducteur dopée p, en fonction de la densité de courant, en A/cm², dans la LED pour différentes valeurs de différence de potentiels entre la grille et l'anode. Par rapport à la LED utilisée pour la précédente simulation dont l'efficacité quantique interne obtenue est représentée sur la figure 4, le diamètre de la structure mesa de la LED dont l'efficacité quantique interne est représentée sur la figure 5 est égal à 5 µm, et égal à 10 µm pour la figure 6.

Les courbes 30 et 40 représentent l'efficacité quantique interne obtenue dans ces LEDs lorsque Vg = 0V. Les courbes 32 et 42 représentent l'efficacité quantique interne obtenue dans ces LEDs lorsque Vg = -10V. Les courbes 34 et 44 représentent l'efficacité quantique interne obtenue dans des LEDs similaires mais ne comportant de grille formée autour des jonctions des LEDs. Les courbes 36 et 46 représentent l'efficacité quantique interne obtenue dans ces LEDs lorsque Vg = 10V.

Les figures 4 à 6 illustrent le fait que l'effet du champ électrique créé par la grille est visible jusqu'à des diamètres de mesas de 10 µm. De plus, cet effet est notable jusqu'à des diamètres de structures mesa d'environ 50 µm. Les figures 5 et 6 montrent également que l'effet reste intéressant pour des densités de courant plus faibles lorsque la taille de la structure mesa de la LED augmente : dans le cas d'une structure mésa de 5 µm de diamètre, l'efficacité quantique interne chute à environ 30 % pour une densité de courant de 1000 A/cm² et une tension Vg de -10 V, alors que pour une structure mesa de 10 µm de diamètre, l'efficacité quantique interne est d'environ 20 % pour une densité de courant de 1000 A/cm² et elle est d'environ 40 % pour une densité de courant de 300 A/cm².

Cet effet de champ créé par la grille déposée autour d'une jonction p-n ou p-i-n est aussi très intéressant dans le cas de jonctions p-n ou p-i-n réalisées à base de matériaux de plus grands gaps que celui du GaN, tels que l'AlGaN. Dans de tels matériaux, l'énergie d'ionisation des accepteurs est encore plus élevée que dans le GaN. Ainsi, dans l'AlGaN, avec environ 40 % d'aluminium, l'énergie d'ionisation des accepteurs est d'environ 300 meV. Pour de l'AlN, l'énergie d'ionisation des accepteurs est de l'ordre de 600 meV. Pour de l'AlN avec environ 70 % d'aluminium, l'énergie d'ionisation des accepteurs est de l'ordre de 450 meV. L'utilisation de couches barrières avec environ 70 % d'aluminium permet de réaliser des puits quantiques avec de l'AlGaN avec environ 45 % d'aluminium et d'obtenir une émission lumineuse depuis ces puits quantiques à environ 4,7 eV, soit à des longueurs d'ondes d'environ 260 nm se trouvant dans le domaine des ultra-violets. Cette longueur d'onde d'émission émission est très intéressante car elle est adaptée à la désinfection de l'eau du fait que cette longueur d'onde de 260 nm tue les bactéries dans l'eau.

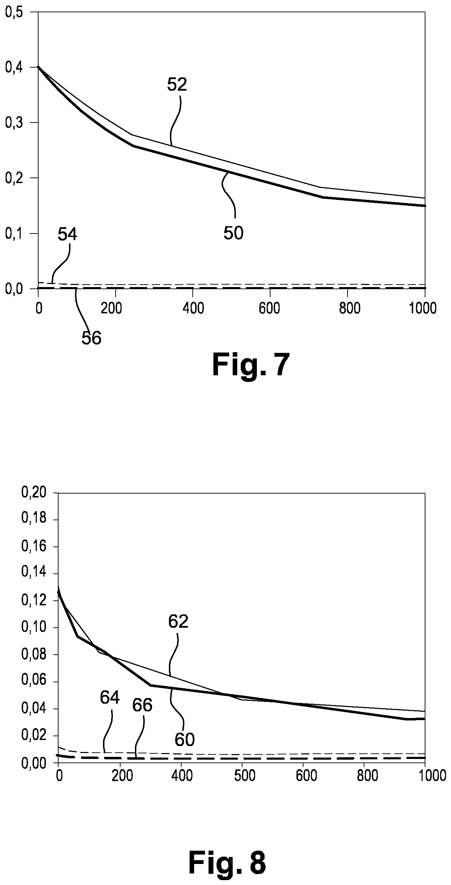

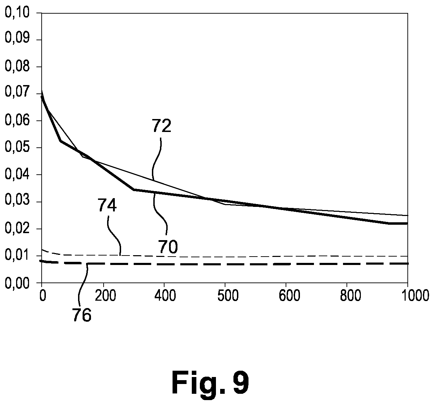

Les figures 7 à 9 représentent l'efficacité quantique interne obtenue dans une LED de structure mesa émettant à une longueur d'onde d'environ 260 nm. Comme dans les précédentes simulations, la LED simulée ne comporte pas les parties 114 et la cathode 116 n'est pas disposée autour de la grille 118 mais est disposée sous la deuxième portion de semi-conducteur dopée n 108, directement en contact avec elle. Les portions 106 et 108 de semi-conducteur dopées p et n comportent de l'Al_{0,7}Ga_{0,3}N comportant une concentration égale à 10¹⁷ accepteurs/cm³ pour la portion dopée p 106 et une concentration égale à 10¹⁸ donneurs/cm³ pour la portion dopée n 108. La zone active 104 de la LED simulée comporte un seul puits quantique d'Al_{0,4}Ga_{0,6}N réalisé dans une couche d'Al_{0,7}G_{0,3}N non intentionnellement dopée et de concentration en donneurs résiduels n_{nid} égale à environ 10¹⁷ donneurs/cm³, formant les couches barrières de la zone active 104. Les portions 106 et 108 de semi-conducteur dopées p et n, la zone active 104 et les électrodes 112 et 116 sont réalisées sous la forme d'une structure de mesa cylindrique de diamètre égal à 1 µm pour la figure 7, à 5 µm pour la figure 8 et à 10 µm pour la figure 9. En outre, la grille 118 est réalisée sur toute la hauteur de la jonction de la LED, autour des portions de semi-conducteur dopée p et n 106 et 108, et autour de la zone active 104.

Les courbes 50, 60 et 70 représentent l'efficacité quantique interne obtenue dans ces LEDs lorsque Vg = 0V. Les courbes 52, 62 et 72 représentent l'efficacité quantique interne obtenue dans ces LEDs lorsque Vg = -10V. Les courbes 54, 64 et 74 représentent l'efficacité quantique interne obtenue dans des LEDs similaires mais ne comportant de grille formée autour de la jonction de la LED. Les courbes 56, 66 et 76 représentent l'efficacité quantique interne obtenue dans ces LEDs lorsque Vg = 10V.

Comme précédemment, les courbes représentées sur les figures 7 à 9 montrent que l'efficacité quantique interne d'une telle LED peut être grandement augmentée en utilisant une grille 118 autour de la jonction. Cela serait également le cas du moment que la grille 118 est disposée en regard d'au moins une partie de la portion de semi-conducteur dopée p 106, au niveau de l'interface avec la zone active 104.

La grille 118 permet aussi de compenser les effets néfastes d'un éventuel trop fort dopage n_{id} dans la zone active 104 ou d'un éventuel trop faible dopage de la portion de semi-conducteur dopée p 106.

L'effet de la grille autour du semi-conducteur dopé p est bénéfique quelle que soit la structure de la zone active : avec ou sans couche de blocage d'électrons, et quel que soit le nombre de puits quantiques. Dans le cas d'une LED comportant une couche de blocage d'électrons en AIGaN de type p disposée entre la portion 106 de semi-conducteur dopée p et la zone active 104, il est aussi bénéfique de former la grille 118 autour de la couche de blocage d'électrons.

La présence de cette grille permet aussi d'avoir de bonnes efficacités quantiques interne sans utiliser de couche de blocage d'électrons dans la LED.

Dans l'exemple de réalisation précédemment décrit en liaison avec la figure 1, la grille 118 est réalisée autour de la première électrode 112, de la première portion de matériau semi-conducteur dopée p 106, de la zone active 104 et d'une partie de la hauteur (dimension selon l'axe Z) la deuxième portion de matériau semi-conducteur dopée n 108. En variante, la grille 118 peut être réalisée sur toute la hauteur de la jonction de la LED 100, c'est-à-dire également au niveau de toute la hauteur de la deuxième portion de matériau semi-conducteur dopée n 108. Selon d'autres variantes, la grille 118 peut être réalisée :
- uniquement autour de la première électrode 112, de la première portion de semi-conducteur dopée p 106 et de la zone active 104, ou bien
- uniquement autour de la première électrode 112, de la première portion de semi-conducteur dopée p 106 et d'une partie de la zone active 104, ou encore
- uniquement autour de la première électrode 112 et de la première portion de semi-conducteur dopée p 106, ou
- uniquement autour de la première portion de semi-conducteur dopée p 106 (avec dans ce cas un matériau comblant l'espace entre le sommet de la grille 118 et la face supérieure 122 qui est sensiblement plane), ou
- uniquement autour d'une partie de la première portion de semi-conducteur dopée p 106 qui est localisée au niveau de la jonction, c'est-à-dire en contact avec la zone active 104 (avec dans ce cas un matériau comblant l'espace entre le sommet de la grille 118 et la face supérieure 122 qui est sensiblement plane).

En outre, il est possible que la grille 118 n'entoure que partiellement les éléments de la structure mesa 124 précédemment mentionnés. La grille 118 peut être disposée au niveau d'un seul ou de plusieurs côtés de la structure mesa 124 de la LED 100.

Une couche de blocage d'électrons, par exemple en AIGaN avec une concentration en aluminium entre 8 % et 15 % et dopée p peut en outre être disposée entre la zone active 104 et la première portion de semi-conducteur dopée p 106.

Selon une variante, la structure mesa 124 de la LED 100 peut ne pas comporter la zone active 104, et la première portion de semi-conducteur dopée p 106 est alors disposée directement sur la deuxième portion de semi-conducteur dopées n 108. La zone de charge d'espace se trouve alors dans une partie de chacune des portions 106, 108 qui se trouvent l'une contre l'autre.

La structure mesa 124 de la LED 100 peut former un plot d'une section de forme quelconque, ou une portion de forme allongée (rectiligne ou courbe), ou même une portion d'une toute autre forme du moment que cette forme de la structure mesa 124 permette de former une diode électroluminescente.

En variante du SiN utilisé pour réaliser la couche de passivation diélectrique 120, cette couche de passivation diélectrique 120 peut comporter un matériau diélectrique de type High-k tel que du HfO₂ ou du ZrO₂, ce qui permet d'obtenir dans la structure mesa 124 un champ électrique plus important que dans le cas d'une couche de passivation diélectrique 120 formée avec un matériau diélectrique de plus faible permittivité électrique comme le SiN.

La couche de passivation diélectrique 120 en SiN peut avantageusement avoir une épaisseur au moins égale à 50 nm pour éviter un claquage lorsque la différence de potentiels entre la grille et l'anode peut atteindre environ 15 V. De préférence, l'épaisseur de la couche de passivation diélectrique 120 est choisie telle qu'elle puisse supporter une différence de potentiels d'environ 20 V sans claquage, cette épaisseur étant fonction du matériau utilisé pour réaliser la couche de passivation diélectrique 120.

Plusieurs LEDs similaires à la LED 100 peuvent être réalisées les unes à côté des autres sur le substrat 102. De plus, la deuxième couche de semi-conducteur dopée n peut former un socle commun à toutes les LEDs et former toutes les deuxièmes portions 108 de ces LEDs. Les deuxièmes électrodes 116 de ces LEDs peuvent former dans ce cas une électrode commune, par exemple une cathode commune, à l'ensemble des LEDs, l'adressage individuel des LEDs étant réalisé par l'intermédiaire de la première électrode 112 propre à chacune des LEDs.

Bien qu'il soit préférable de fixer le potentiel électrique de la grille de chacune des LEDs pour maîtriser l'effet d'ionisation des dopants, il est possible que ce potentiel ne soit pas fixé et soit laissé flottant, et que seuls les potentiels appliqués sur les électrodes soient fixés.

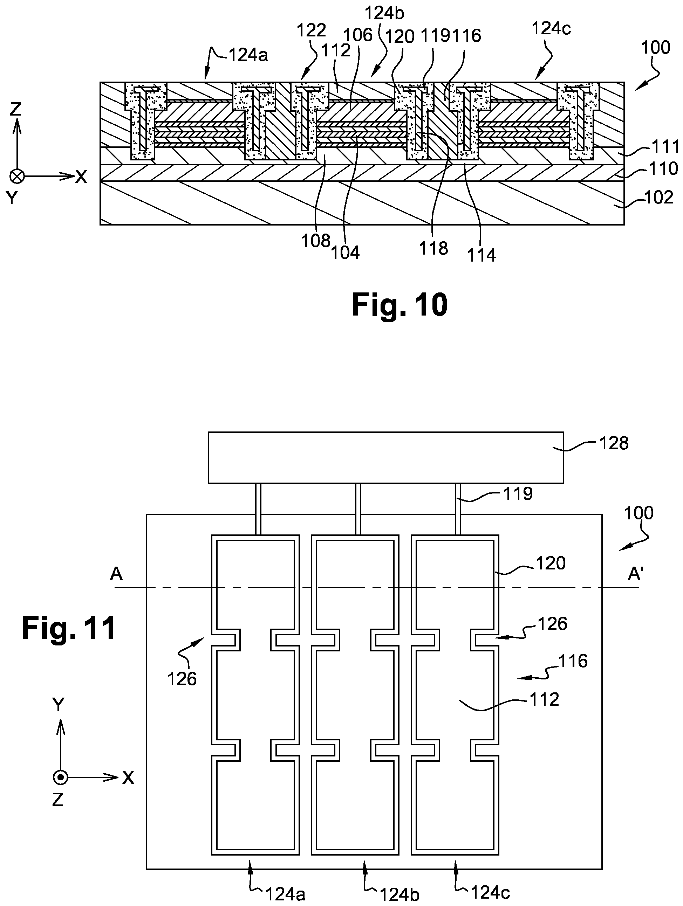

Les figures 10 et 11 représentent respectivement une vue en coupe (selon l'axe AA' représenté sur la figure 11) et une vue de dessus schématiques d'un dispositif optoélectronique 100 selon un deuxième mode de réalisation, ici une LED, comportant plusieurs régions formant des structures mesa 124a, 124b et 124c disposées les unes à côté des autres. Les structures mesa 124a, 124b et 124c de la LED 100 selon ce deuxième mode de réalisation sont formées des mêmes couches de matériaux que ceux formant la structure mesa 124 de la LED 100 selon le premier mode de réalisation.

Les structures mesa 124a, 124b et 124c de la LED 100 forment schématiquement plusieurs portions longilignes (trois sur l'exemple de réalisation représenté sur les figures 10 et 11) disposées parallèlement les unes à côté des autres, et entourées chacune par une grille 118. De plus, le profil de chacune de ces portions n'est ici pas totalement rectiligne et comporte des « creux » 126 permettant d'augmenter la surface de contact des grilles 118 avec les structures mesa 124a, 124b et 124c. En outre, dans ce deuxième mode de réalisation, les surfaces supérieures des grilles 118 qui forment une partie de la surface supérieure plane 122 dans le premier mode de réalisation sont ici recouvertes par des contacts électriques 119 eux-mêmes recouverts par des parties des couches de passivation diélectriques 120 qui entourent donc complètement les grilles 118 et les contacts électriques 119. Les grilles 118 sont accessibles électriquement via un contact électrique 128 déporté, ou éloigné, par rapport aux autres éléments de la LED 100 et auquel sont reliées les grilles 118 de la LED 100 par l'intermédiaire des contacts électriques 119.

Comme dans le premier mode de réalisation, la deuxième couche de semi-conducteur dopée n 111 forme les portions 108 dopées n et les parties 114 sur lesquelles reposent les deuxièmes électrodes 116 formant ici les cathodes. Les deuxièmes électrodes 116 sont reliées électriquement aux deuxièmes portions 108 dopées n via les parties 114 de cette deuxième couche de semi-conducteur dopée n 111. De plus, la LED 100 selon le deuxième mode de réalisation comporte la surface supérieure 122 qui est sensiblement plane et formée par les faces supérieures des électrodes 112 et 116 ainsi que par les faces supérieures des couches de passivation diélectriques 120 (qui recouvrent les grilles 118 et les contacts électriques 119).

Les électrodes 112 et 116 peuvent être par exemple formées par la superposition de plusieurs matériaux électriquement conducteurs.

Les structures mesa 124a, 124b et 124c pourraient être d'une toute autre forme que celles représentées sur l'exemple des figures 10 et 11.

En outre, les différentes variantes et détails de réalisation précédemment décrits pour le premier mode de réalisation (relatives aux matériaux utilisés, aux éléments de la structure mesa entourés par la grille, à la grille entourant ou non complètement la structure mesa, etc.) peuvent également s'appliquer au deuxième mode de réalisation.

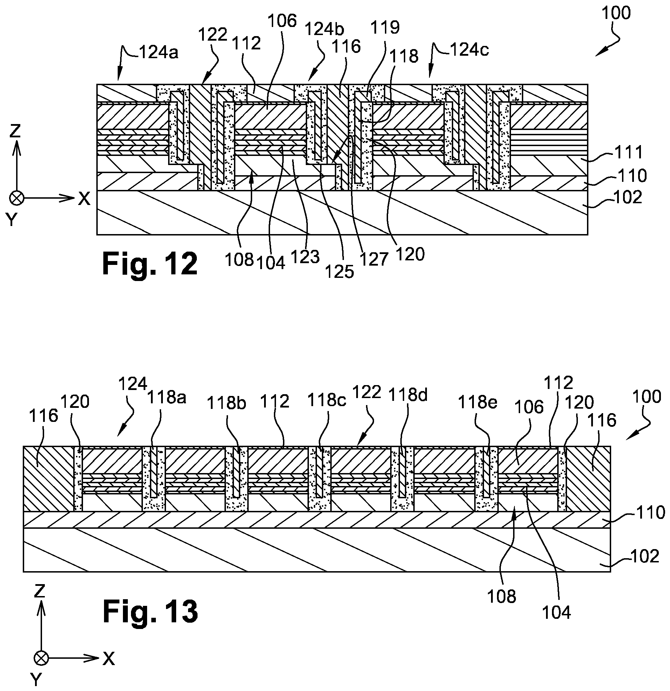

La figure 12 représente une vue en coupe de profil d'un dispositif optoélectronique 100 selon une variante du deuxième mode de réalisation précédemment décrit.

Dans cette variante, une première partie 123 de la deuxième portion de semi-conducteur 108 disposée entre une deuxième partie 125 de la deuxième portion de semi-conducteur 108 et la zone active 104 forme un décrochement, ou un renfoncement, par rapport à la deuxième partie 125 de la deuxième portion de semi-conducteur 108. Une première partie de chacune des deuxièmes électrodes 116 traverse toute la deuxième couche de semi-conducteur dopée n 111 ainsi que la couche tampon 110 et repose directement sur le substrat 102. Une deuxième partie de chacune des deuxièmes électrodes 116 adjacente à la première partie repose sur une face supérieure 127 de la deuxième partie 125 de la deuxième portion de semi-conducteur 108, et est reliée électriquement à la deuxième portion 108 de la structure mesa adjacente au niveau de cette face supérieure 127. Chacune des structures mesa 124a, 124b et 124c est entourée par la grille 118 qui s'étend d'un côté (qui ne comporte pas le décrochement) sur toute la hauteur de la structure mesa et de l'autre (qui comporte le décrochement) sur une partie seulement de la hauteur de la structure mesa. La partie de la grille 118 qui se trouve au niveau du décrochement repose sur la face supérieure 127. Une partie de la couche de passivation diélectrique 120 est interposée entre la grille 118 et la face supérieure 127.

Cette variante a pour avantage de permettre une interconnexion en série des dispositifs optoélectroniques en reliant, pour chaque dispositif interconnecté, la deuxième électrode 116 à la première électrode 112 du dispositif adjacent.

Cette variante du deuxième mode de réalisation peut également s'appliquer au premier mode de réalisation précédemment décrit.

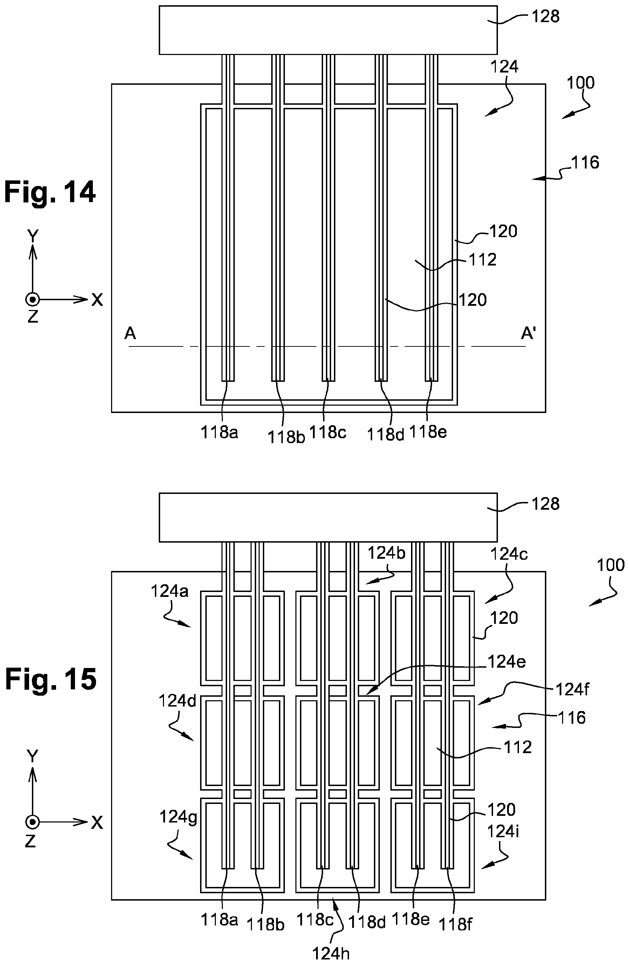

Les figures 13 et 14 représentent respectivement une vue en coupe (selon l'axe AA' représenté sur la figure 14) et une vue de dessus schématiques d'un dispositif optoélectronique 100, ici une LED, selon un troisième mode de réalisation

La LED 100 comporte une seule structure mesa 124 qui, sur l'exemple des figures 13 et 14, comporte une section, dans le plan (X,Y), de forme sensiblement rectangulaire, et est formée des mêmes couches de matériaux que celles formant la structure mesa 124 de la LED 100 selon le premier mode de réalisation.

Dans ce troisième mode de réalisation, la structure mesa 124 n'est pas entourée par la grille 118 mais est traversée par plusieurs portions de matériau électriquement conducteur 118a - 118e (au nombre de 5 sur l'exemple des figures 13 et 14) s'étendant dans la structure mesa 124 et formant ensemble la grille 118. Sur l'exemple décrit ici, les portions 118a - 118e correspondent à des portions de forme rectiligne s'étendant dans une direction parallèle à la surface sensiblement plane 122 (parallèlement à l'axe Y sur la figure 14). Chacune des portions de matériau électriquement conducteur 118a - 118e est entourée, au niveau des flancs latéraux et de la face inférieure de ces portions, de la couche de passivation diélectrique 120 assurant l'isolation électrique entre les portions 118a - 118e et les matériaux de la structure mesa 124. Dans ce troisième mode de réalisation, la couche de passivation diélectrique 120 comporte avantageusement un matériau diélectrique de type High-k tel que du HfO₂ ou du ZrO₂, mais pourrait également comporter un matériau diélectrique de plus faible permittivité. Les portions de matériau électriquement conducteur 118a - 118e sont reliées électriquement au contact électrique 128 déporté par rapport aux autres éléments de la LED 100.

La deuxième électrode 116 est formée par une portion de matériau électriquement conducteur entourant la structure mesa 124, comme dans le premier mode de réalisation, et en contact avec la couche tampon 110 qui assure la liaison électrique entre la deuxième électrode 116 et la deuxième portion de semi-conducteur dopée n 108. Des parties de la couche de passivation diélectrique 120 recouvrent également les flancs latéraux extérieurs de la structure mesa 124 et isolent ainsi électriquement les autres éléments de la structure mesa 124 (première électrode 112, première portion de semi-conducteur dopée p 106, zone active 104) vis-à-vis de la deuxième électrode 116.

Avec une telle structure, l'efficacité quantique interne de la LED 100 est améliorée grâce à la présence de la grille 118 dans la structure mesa 124 qui permet de générer un champ électrique de manière analogue aux précédents modes de réalisation dans lesquels la ou les grilles 118 entourent la ou les structures mesa. Les portions de matériau électriquement conducteur 118a - 118e formant la grille 118 peuvent avoir une forme différente, rectiligne ou non, de celle de l'exemple des figures 13 et 14, et/ou la grille 118 peut comporter un nombre différent de portions de matériau électriquement conducteur formant la grille 118, notamment selon les dimensions de la structure mesa 124 de la LED 100.

Les caractéristiques précédemment décrites pour le premier mode de réalisation relatives au diamètre de la structure mesa en fonction des matériaux utilisés s'appliquent de manière analogue aux distances entre les portions de matériau électriquement conducteur 118a - 118e formant la grille 118, en fonction des matériaux formant la structure mesa 124 de cette LED 100. Les différentes variantes et détails de réalisation précédemment décrits pour les deux précédents modes de réalisation peuvent également s'appliquer à ce troisième mode de réalisation.

La figure 15 représente une vue de dessus d'un dispositif optoélectronique 100 selon une variante du troisième mode de réalisation.

Selon cette variante, la structure mesa 124 est formée de plusieurs plots, ou îlots, disposés les uns à côté des autres, de forme cylindrique, parallélépipédique ou autre. Sur l'exemple de la figure 15, neuf plots 124a - 124i sont disposés en formant une matrice 3x3. La grille 118 est formée par des portions de matériau électriquement conducteur 118a - 118f (six sur l'exemple de la figure 15) s'étendant à travers les plots 124a - 124i. Chacun des plots 124a - 124i est traversé par deux des portions 118a - 118f sur l'exemple de la figure 15, mais pourrait être traversé en variante par un nombre différent de portions de matériau électriquement conducteur formant la grille 118. Chacun des plots 124a - 124i est entouré d'une partie de la couche de passivation diélectrique 120 permettant d'isoler électriquement la deuxième électrode 116 qui entoure chacun des plots 124a - 124i.

Le nombre et/ou la forme des plots formant la structure mesa 124, ainsi que le nombre et/ou la forme des portions de matériau électriquement conducteur formant la grille 118 peuvent être différents de ceux de l'exemple de la figure 15.

Dans tous les modes de réalisation, la grille 118 est avantageusement réalisée la plus « dense » possible par rapport à la ou aux structures mesa 124, c'est-à-dire telle que la surface de contact entre la grille 118 et la ou les structures mesa 124 soit la plus grande possible.

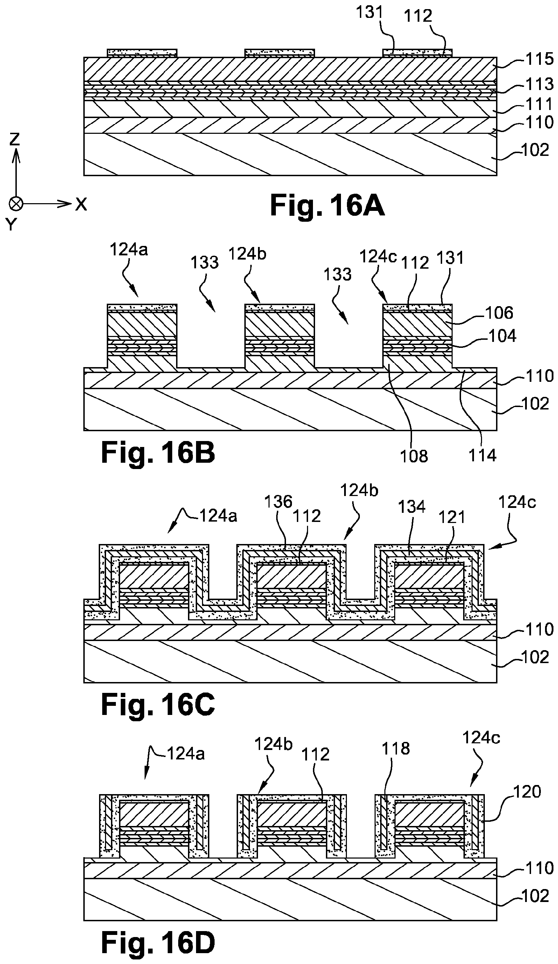

Les figures 16A à 16L représentent schématiquement les étapes d'un procédé de réalisation du dispositif optoélectronique 100, ici une LED, selon le deuxième mode de réalisation. Ces figures représentent des vues en coupe de profil de la structure formant le dispositif optoélectronique 100.

Comme représenté sur la figure 16A, on réalise tout d'abord, sur le substrat 102, l'empilement de couches à partir duquel les structures mesa 124 de la LED 100 vont être réalisées. Cet empilement comporte, dans le sens allant de la face supérieure de l'empilement jusqu'à la face inférieure de l'empilement en contact avec le substrat 102, une première couche de semi-conducteur dopée p 115 (comportant ici du GaN), des couches actives 113 correspondant à un empilement alterné d'une ou plusieurs couches émissives à puits quantiques, comportant par exemple de l'InGaN, et de couches barrières, comportant par exemple du GaN, une deuxième couche de semi-conducteur dopée n 111, comportant par exemple du GaN, et la couche tampon 110, comportant par exemple du GaN dopé n.

Les premières électrodes 112 destinées à former les anodes de la LED 100 sont ensuite réalisées sur la première couche de semi-conducteur dopée p 115, par exemple via un dépôt puis une lithographie et une gravure d'une première couche de matériau électriquement conducteur, comportant par exemple de l'aluminium. Les premières électrodes 112 ont chacune une forme et des dimensions, dans le plan de la face supérieure de la première couche de semi-conducteur dopée p 115 sur laquelle elles sont réalisées, sensiblement similaires à celles souhaitées pour les structures mesa 124 de la LED 100, et par exemple une section en forme de disque. Un masque dur 131 est réalisé sur la première couche de matériau électriquement conducteur destinée à former les premières électrodes 112 tel que des ouvertures formées dans ce masque 131 correspondent aux motifs à graver dans l'empilement de couches sur lequel le masque dur 131 est formé afin de définir les premières électrodes 112 et les structures mesa 124 de la LED 100. Dans l'exemple de réalisation décrit ici, les portions du masque dur 131 ont une forme et des dimensions, dans le plan de la face supérieure de la première couche de semi-conducteur dopée p 115 sur laquelle les premières électrodes 112 sont réalisées, sensiblement similaires à celles des premières électrodes 112.

Comme représenté sur la figure 16B, une gravure de la première couche de semi-conducteur dopée p 115, des couches actives 113 et d'une partie de l'épaisseur de la deuxième couche de semi-conducteur dopée n 111 est également mise en œuvre selon le motif défini par le masque dur 131, formant les structures mesa 124a, 124b et 124c, par exemple de forme cylindrique, comprenant chacune la zone active 104 disposée entre la première portion de semi-conducteur dopée p 106 et la deuxième portion de semi-conducteur dopée n 108. Cette gravure est stoppée à un niveau de profondeur situé dans la deuxième couche de semi-conducteur dopée n 111 telle qu'une portion 114 de cette deuxième couche 111 soit conservée au fond de chacune des zones gravées de l'empilement (sur lesquelles reposeront les deuxièmes électrodes 116). Cette étape de gravure forme, autour des structures mesa 124, des espaces vides 133 qui serviront par la suite à la réalisation des deuxièmes électrodes 116, de la couche de passivation diélectrique 120 et des grilles 118. La gravure mise en œuvre est une gravure sèche, par exemple une gravure ionique réactive avec un plasma de Cl₂. Cette gravure délimite les structures mesa 124.

Le masque dur 131 peut être supprimé ou non avant la mise en œuvre des étapes suivantes. De plus, la gravure des électrodes 112 et celle des structures mesa 124 sont mises en œuvre de préférence au cours d'une même étape de gravure.

Une première couche diélectrique 121, comportant par exemple du SiN ou un matériau diélectrique High-k selon le matériau souhaité pour former la couche de passivation diélectrique 120, est ensuite déposée avec une épaisseur conforme, par exemple égale à 10 nm, sur les portions du masque dur 131 et le long des parois des espaces vides 133, recouvrant donc les parois latérales des premières électrodes 112, des premières portions de semi-conducteur dopées p 106, des zones actives 104 et des deuxièmes portions de semi-conducteur dopées n 108. Cette première couche diélectrique 121 est également déposée sur les parties 114 non gravées de la deuxième couche de semi-conducteur dopée n 111 formant les parois de fond des espaces vides 133. Une deuxième couche de matériau électriquement conducteur 134 destinée à former les grilles 118, par exemple en aluminium et d'épaisseur égale à environ 500 nm, est ensuite déposée de manière conforme sur la première couche diélectrique 121. Une deuxième couche diélectrique 136, comportant par exemple du SiN ou un matériau diélectrique High-k et d'épaisseur égale à 100 nm, ou plus généralement au moins égale à 5 nm, est ensuite déposée sur la deuxième couche de matériau électriquement conducteur 134 (figure 16C).

Une gravure directive de la deuxième couche diélectrique 136, via un plasma de SF₆, et de la deuxième couche de matériau électriquement conducteur 134, via un plasma de type Cl₂ argon, est ensuite mise en œuvre telle que des portions restantes de la deuxième couche diélectrique 136 et de la deuxième couche de matériau électriquement conducteur 134 recouvrent les parois latérales des espaces vides 133, c'est-à-dire les flancs latéraux des structures mesa 124 (figure 16D). Les portions restantes de la deuxième couche de matériau électriquement conducteur 134 forment les grilles 118 entourant les structures mesa 124, et les portions restantes des couches diélectriques 121 et 136 forment des parties de la couche de passivation diélectrique 120.

De manière avantageuse, la couche diélectrique 121 et la couche de matériau électriquement conducteur 134 sont gravées avant le dépôt de la deuxième couche diélectrique 136. La deuxième couche diélectrique 136 est ensuite déposée, ce qui permet de bien entourer les parties inférieures des portions restantes de la couche conductrice 134 par du diélectrique, comme représenté sur la figure 16D. Une autre gravure peut ensuite être mise en œuvre pour former les accès à la deuxième couche de semi-conducteur dopée n 111 entre les structures mesa 124.

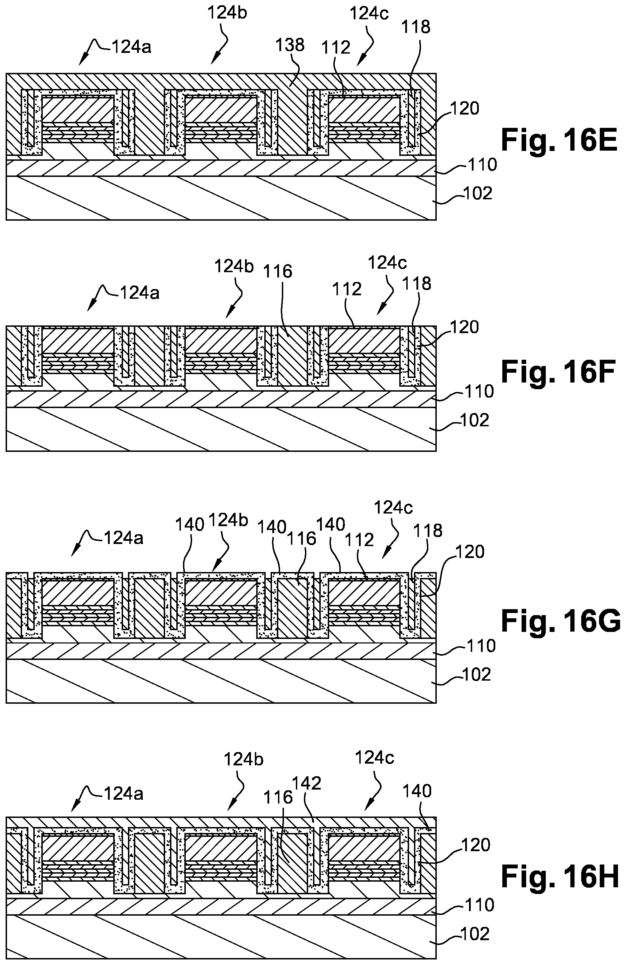

Un dépôt d'une troisième couche de matériau électriquement conducteur 138 est ensuite réalisé afin de remplir les espaces vides 133 (figure 16E). Ce dépôt est réalisé sur l'ensemble de la structure et recouvre également les structures mesa 124. Ce dépôt est par exemple obtenu via un dépôt d'une couche de titane d'épaisseur égale à environ 20 nm, puis un dépôt d'une couche d'aluminium d'épaisseur égale à environ 1 µm.

Comme représenté sur la figure 16F, une planarisation mécano-chimique (CMP) est ensuite mise en œuvre afin de supprimer les parties de la troisième couche 138 recouvrant les structures mesa 124 et supprimer aussi les parties de la couche de passivation 120 recouvrant les structures mesa 124. Cette CMP est mise en œuvre en prenant comme surface d'arrêt les faces supérieures des premières électrodes 112. Les portions restantes de la couche 138 forment les deuxièmes électrodes 116.

Un dépôt d'une troisième couche diélectrique 140, comportant par exemple du SiN ou un diélectrique High-k, et d'épaisseur égale à environ 100 nm, est ensuite réalisé, cette troisième couche diélectrique 140 étant ensuite gravée afin que des portions restantes de cette troisième couche diélectrique 140 ne recouvrent pas les grilles 118 (figure 16G).

Un dépôt d'une quatrième couche de matériau électriquement conducteur 142 est ensuite réalisé sur toute la structure (figure 16H) afin de réaliser, après une gravure, les contacts électriques 119 sur les grilles 118 ainsi que le contact électrique déporté 128 par rapport aux structures mesa 124 et auquel les grilles 118 sont reliées via les contacts électriques 119. Ce matériau électriquement conducteur correspond par exemple à de l'aluminium déposé sur une épaisseur d'environ 100 nm.

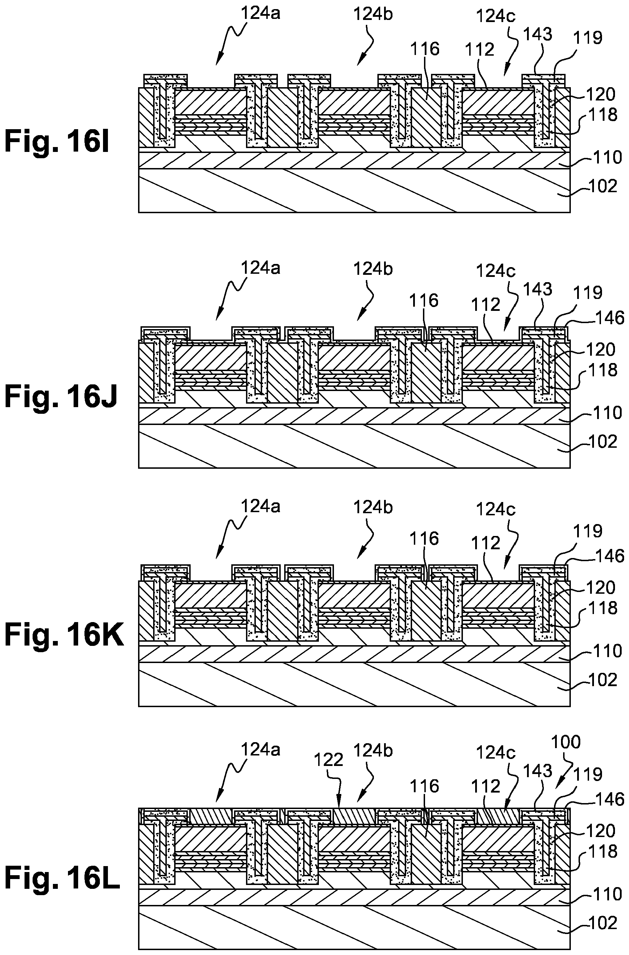

Comme représenté sur la figure 16I, une quatrième couche diélectrique 143 (SiN ou diélectrique High-k) est déposée sur la quatrième couche de matériau électriquement conducteur 142, puis cette quatrième couche diélectrique 143 et la quatrième couche de matériau électriquement conducteur 142 sont gravées afin que des portions restantes de la quatrième couche de matériau électriquement conducteur 142 forment les contacts électriques 119 disposés sur les grilles 118 et relient électriquement les grilles 118 au contact déporté 128, et que des portions restantes de la quatrième couche diélectrique 143, faisant partie de la couche de passivation diélectrique 120, recouvrent les contacts électriques 119. Des parties de la troisième couche diélectrique 140 recouvrant les électrodes 112 et 116 sont également gravées afin de former des accès aux électrodes 112 et 116.

Une cinquième couche de matériau diélectrique 146 (SiN ou diélectrique High-k) est déposée sur l'ensemble de la structure, par exemple avec une épaisseur égale à environ 100 nm (figure 16J), puis les parties de cette cinquième couche diélectrique 146 recouvrant les électrodes 112 et 116 sont gravées afin de former des accès aux électrodes 112 et 116 (figure 16K). Des portions restantes de cette cinquième couche de matériau diélectrique 146 recouvrent les flancs latéraux des contacts électriques 119 et forment, avec les portions restantes des autres couches diélectriques, les couches de passivation diélectriques 120 entourant les grilles 118 et les contacts électriques 119.

La LED 100 est achevée en déposant une cinquième couche de matériau électriquement conducteur sur l'ensemble de la structure et en mettant en œuvre une CMP avec arrêt sur les couches de passivation diélectriques 120, formant ainsi des portions métalliques prolongeant les électrodes 112 et 116 à un même niveau que les couches de passivation diélectriques 120 (figure 16L). Cette dernière étape de CMP peut former, au niveau de la face supérieure 122 sensiblement plane, les légers creux au niveau des contacts métalliques par rapport aux couches de passivation diélectriques 120.

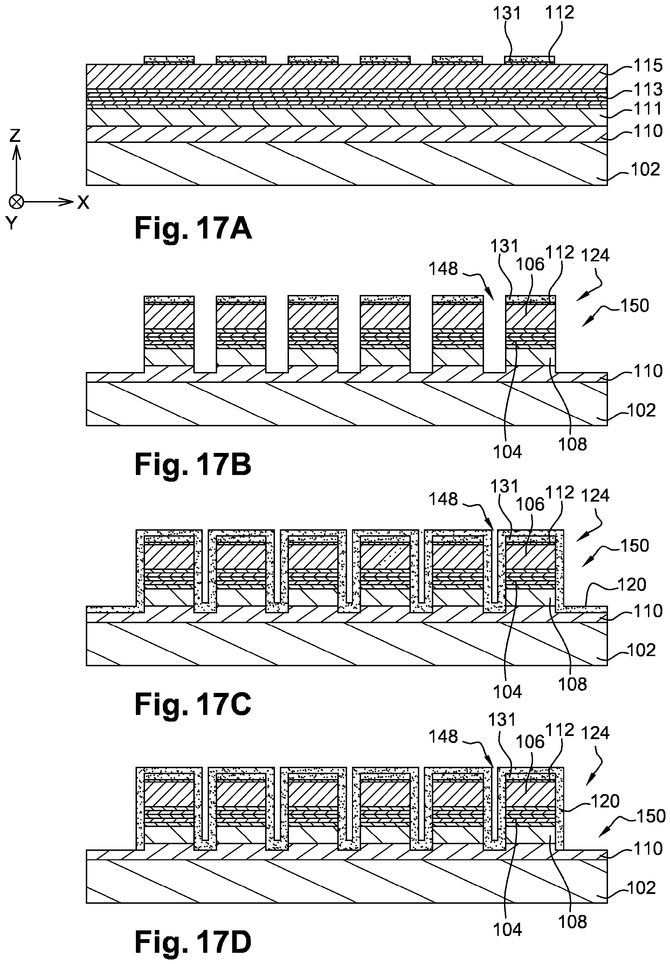

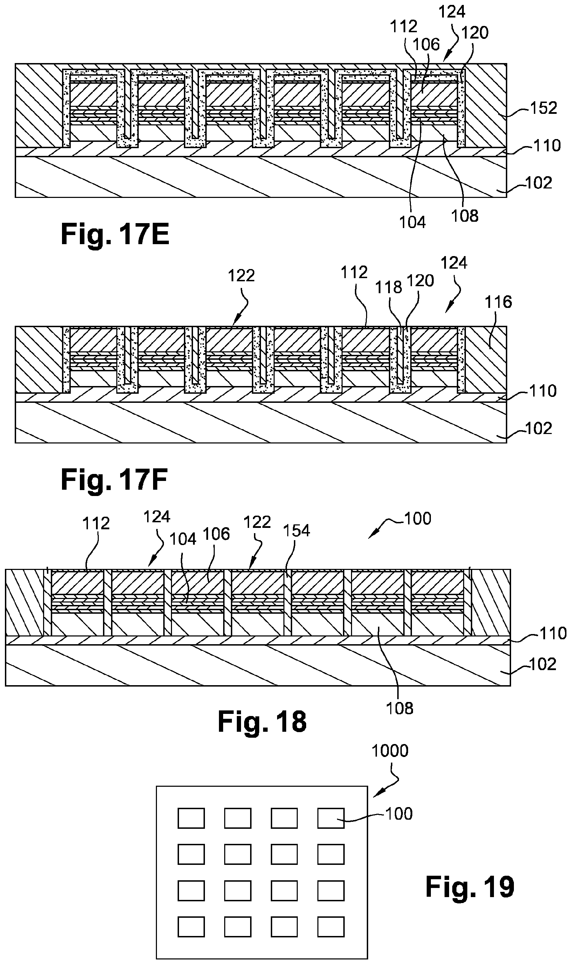

Les figures 17A à 17F représentent les étapes d'un procédé de réalisation du dispositif optoélectronique 100, ici une LED, selon le troisième mode de réalisation précédemment décrit. Ces figures représentent des vues en coupe de profil de la structure destinée à former la LED 100.

Comme représenté sur la figure 17A, on réalise tout d'abord, sur le substrat 102, l'empilement de couches à partir duquel la structure mesa 124 de la LED 100 va être réalisée. Cet empilement est similaire à celui précédemment décrit en liaison avec la figure 16A. En outre, les premières électrodes 112 et le masque dur 131 sont réalisés sur la structure précédemment formée tel que des ouvertures formées dans ce masque 131 correspondent aux motifs à graver dans l'empilement de couches sur lequel le masque dur 131 est formé afin de définir les emplacements dans lesquels la grille 118 traversera la structure mesa 124 de la LED 100.

Comme représenté sur la figure 17B, une gravure de la première couche de semi-conducteur dopée p 115, des couches actives 113 et de la deuxième couche de semi-conducteur dopée n 111 et d'une partie de l'épaisseur de la couche tampon 110 est ensuite mise en œuvre selon le motif défini par le masque dur 131, formant dans la structure mesa 124 des emplacements 148 dans lesquels les portions électriquement conductrices de la grille 118 sont destinées à traverser la structure mesa 124. Cette gravure est également réalisée sur la périphérie de la structure mesa 124 afin de former les emplacements 150 au niveau desquels la deuxième électrode 116 sera réalisée. Cette gravure est stoppée à un niveau de profondeur situé dans la couche tampon 110. Il est toutefois possible que cette gravure soit stoppée à un autre niveau, par exemple au niveau de la face supérieure de la couche tampon 110 ou dans la couche 111. La gravure mise en œuvre est une gravure sèche, par exemple une gravure ionique réactive avec un plasma de Cl₂.

La couche de passivation diélectrique 120 est ensuite déposée de manière conforme sur la structure, c'est-à-dire à la fois sur la structure mesa 124 et dans les emplacements 148 et 150 en recouvrant l'ensemble des parois (parois latérales et parois de fond) de ces emplacements (figure 17C). Cette couche de passivation diélectrique 120 est par exemple ici du HfO₂ déposé par ALD.

Les parties de la couche de passivation diélectrique 120 recouvrant les parois de fond des emplacements 150 de la deuxième électrode 116 sont ensuite gravées, par exemple via une gravure plasma de type Cl₂ en masquant les autres parties de la couche de passivation diélectrique 120 à conserver, par exemple avec de la résine (figure 17D).

Un dépôt d'une couche de matériau électriquement conducteur 152 pleine plaque est ensuite réalisé, remplissant les emplacements 148 et 150 (figure 17E), puis une CMP est mise en œuvre avec arrêt sur les premières électrodes 112, formant ainsi la deuxième électrode 116 ainsi que la couche de passivation diélectrique 120.

En variante du GaN, de l'InGaN et de l'AlGaN, la jonction p-n ou p-i-n du dispositif optoélectronique 100 peut être réalisée à partir de ZnO. Pour la réalisation d'une telle jonction, une hétérostructure de ZnO en deux dimensions comportant des puits quantiques de ZnCdO ou de ZnMgO peut être tout d'abord réalisée. Une implantation de type P puis un recuit de cette hétérostructure peuvent ensuite être réalisés, comme décrit par exemple dans le document FR 2 981090 A1. Une structure analogue à celle représentée sur la figure 16A est alors obtenue, dans laquelle la couche 115 correspond à une couche de ZnO dopé p (obtenue par exemple par implantation de phosphore), les couches actives 113 correspondent à des puits de ZnO/ZnCdO ou de ZnO/ZnMgO, et la couche 111 correspond à une couche de ZnO dopé n. Des étapes analogues à celles précédemment décrites en liaison avec les figures 16B à 16L peut ensuite être mises en œuvre à partir d'un tel empilement pour achever la réalisation du dispositif 100.

Dans tous les modes de réalisation et variantes précédemment décrits, chaque élément comportant une grille et la couche de passivation disposée autour de la grille et qui permet de réaliser une ionisation des dopants de la jonction via une génération d'un champ électrique dans la jonction peut être remplacée par une ou plusieurs portions métalliques formant un ou plusieurs contacts Schottky avec les matériaux de la jonction p-n ou p-i-n. Dans ce cas, la ou les portions métalliques sont directement en contact avec les matériaux semi-conducteurs de la jonction, sans matériau d'isolation disposé entre les matériaux semi-conducteurs et le matériau métallique. Pour former un tel contact Schottky, le métal utilisé est choisi parmi des métaux présentant un travail de sortie important, comme par exemple le tungstène dont le travail de sortie est égal à environ 6,1 eV, ou du platine. Le choix du métal utilisé pour former de tels contacts Schottky dépend de la structure du dispositif optoélectronique 100, des matériaux semi-conducteurs utilisés, etc. La figure 18 représente un exemple de réalisation d'un tel dispositif optoélectronique 100, ici de structure analogue au dispositif 100 précédemment décrit en liaison avec les figures 13 et 14, mais dans lequel la structure mesa 124 est traversée par des portions métalliques 154 formant des contacts Schottky avec les matériaux semi-conducteur formant la jonction p-n.

En variante des différents exemples de réalisation précédemment décrits, il est possible que la jonction du dispositif optoélectronique 100 soit réalisée à base de diamant, par exemple dans le cas d'une LED ou d'une photodiode apte à réaliser une émission ou une détection de lumière UV. L'empilement de couches à partir duquel un tel dispositif peut être réalisé peut être formé à partir d'un substrat de graphite naturellement de type p. Une croissance de diamant de type p est ensuite réalisée, puis une couche de diamant de type n est réalisée, par exemple comme décrit dans le document de S. Koizumi et al., « Growth and characterization of phosphorous doped {111} homoepitaxial diamond thin films », Appl. Phys. Lett. 71, 1065 (1997), c'est-à-dire par croissance CVD utilisant de la phosphine comme dopant, sur une épaisseur par exemple égale à environ 300 nm. Des étapes analogues à celles précédemment décrites en liaison avec les figures 16B à 16L peuvent ensuite être mises en œuvre à partir d'un tel empilement pour achever la réalisation du dispositif 100.

Avec un tel dispositif optoélectronique à base de diamant, la ou les grilles ou contacts Schottky ne sont pas utilisés pour ioniser les accepteurs mais pour ioniser les donneurs se trouvant dans le diamant dopé n et qui ont une énergie d'activation élevée. Ainsi, la grille ou le ou les contacts Schottky sont réalisés tel qu'ils recouvrent au moins une partie des flancs latéraux d'au moins une partie de la portion de semi-conducteur dopée n localisée au niveau de la jonction p-n. ou p-i-n, qui seront polarisés positivement (tension Vg positive) afin d'augmenter l'efficacité quantique interne dans la jonction. Dans cette configuration, la première portion de semi-conducteur 106 est avantageusement réalisée avec un semi-conducteur de type n.

Une ou plusieurs LEDs 100 selon l'un des différents modes de réalisation précédemment décrits peuvent être intégrées au sein d'un dispositif émissif lumineux 1000. La figure 19 représente schématiquement un tel dispositif 1000 comportant 9 LED 100 réalisées sur un même substrat 102 sous la forme d'une matrice 3x3.

En variante des différents exemples de réalisation précédemment décrits, la référence 100 peut correspondre non pas à une ou plusieurs LEDs, mais à une ou plusieurs photodiodes comportant des jonctions p-n ou p-i-n. Comme pour les LEDs, la ou les grilles ou contacts Schottky servent dans ce cas à ioniser les dopants (accepteurs ou donneurs) et ainsi ajuster le dopage dans la jonction servant à réaliser la conversion photoélectrique. Par exemple, pour une photodiode 100 destinée à réaliser une détection de lumière UV, si de l'AlGaN est utilisé pour réaliser la jonction p-n (par exemple réalisée par croissance MOCVD d'AlGaN de type n avec environ 50 % d'aluminium dopé au silicium à 10¹⁹ donneurs/cm³ sur une épaisseur d'environ 1 µm puis à 10¹⁷ donneurs/cm³ sur une épaisseur d'environ 500 nm, puis croissance d'AlGaN de type p dopé au magnésium à environ 10¹⁹ accepteurs/cm³ sur une épaisseur d'environ 300 nm) le problème lié à l'énergie d'activation élevée des accepteurs dans le semi-conducteur de type p de retrouve dans une telle photodiode, limitant les performances pour la détection de la lumière UV.

De manière analogue, l'utilisation d'un semi-conducteur de type n présentant une énergie d'activation des donneurs élevée, par exemple du diamant, est également possible pour la réalisation d'une photodiode. Dans ce cas, la ou les grilles ou contacts Schottky permettent de ioniser ces donneurs afin d'améliorer la conductivité du semi-conducteur de type n. De plus, le dispositif 1000 représenté sur la figure 19 peut correspondre non pas à un dispositif émissif lumineux mais à un dispositif photodétecteur comportant plusieurs photodiodes 100.

L'ionisation des dopants réalisée grâce à la ou au(x) grilles(s) ou contact(s) Schottky répond à ce problème de manière analogue à celle précédemment décrite pour les LEDs.

Dans le cas d'un dispositif optoélectronique 100 destiné à réaliser une conversion photoélectrique tel qu'une photodiode, la ou les électrodes 112 se trouvant au sommet des structures mesa sont réalisées à partir d'un matériau transparent aux longueurs d'ondes destinées à être détectées et converties photo-électriquement, par exemple de l'ITO d'épaisseur égale à environ 100 nm. Les deuxièmes électrodes 116 servent dans ce cas de collecteurs d'électrons.

## Revendications

1. Dispositif optoélectronique (100) comportant au moins une structure mesa (124) comprenant au moins :
- une première (106) et une deuxième (108) portions de semi-conducteur, l'une étant dopée p et l'autre étant dopée n, et formant ensemble une jonction p-n,
- une première électrode (112) reliée électriquement à la première portion de semi-conducteur (106) qui est disposée entre la deuxième portion de semi-conducteur (108) et la première électrode (112),
le dispositif optoélectronique (100) comportant en outre au moins :
- une deuxième électrode (116) reliée électriquement à la deuxième portion de semi-conducteur (108),
- un élément (118, 120, 154) apte à ioniser des dopants de la première (106) et/ou deuxième (108) portion de semi-conducteur via une génération d'un champ électrique dans la première (106) et/ou deuxième (108) portion de semi-conducteur, et recouvrant au moins une partie des flancs latéraux d'au moins une partie de la première (106) et/ou de la deuxième (108) portion de semi-conducteur et d'au moins une partie d'une zone de charge d'espace formée par les première (106) et deuxième (108) portions de semi-conducteur,
dans lequel des faces supérieures d'au moins la première électrode (112) et de la deuxième électrode (116) forment une surface continue sensiblement plane (122), et dans lequel l'élément apte à ioniser des dopants de la première (106) et/ou deuxième (108) portion de semi-conducteur comporte :
- au moins une couche de passivation diélectrique (120) recouvrant ladite au moins une partie des flancs latéraux d'au moins une partie de la première (106) et/ou de la deuxième (108) portion de semi-conducteur et d'au moins une partie de la zone de charge d'espace, et au moins une grille (118) électriquement conductrice telle que la couche de passivation diélectrique (120) soit disposée entre la grille (118) et ladite au moins une partie de la première (106) et/ou de la deuxième (108) portion de semi-conducteur et entre la grille (118) et ladite au moins une partie de la zone de charge d'espace, ou
- au moins une portion métallique (154) recouvrant ladite au moins une partie des flancs latéraux d'au moins une partie de la première (106) et/ou de la deuxième (108) portion de semi-conducteur et d'au moins une partie de la zone de charge d'espace et formant un contact Schottky avec ladite au moins une partie de la première (106) et/ou de la deuxième (108) portion de semi-conducteur et avec ladite au moins une partie de la zone de charge d'espace,
et dans lequel la première portion de semi-conducteur (106) est dopée p et comporte au moins un semi-conducteur dont une énergie d'activation des accepteurs est supérieure ou égale à environ 200 meV, ou dans lequel la première portion de semi-conducteur (106) est dopée n et comporte au moins un semi-conducteur dont une énergie d'activation des donneurs est supérieure ou égale à environ 200 meV.

2. Dispositif optoélectronique (100) selon la revendication 1, dans lequel :
- une première partie de la couche de passivation diélectrique (120) entoure latéralement au moins en partie la première électrode (112), la première portion de semi-conducteur (106) et au moins une partie de la deuxième portion de semi-conducteur (108),
- la grille (118) recouvre latéralement la première partie de la couche de passivation diélectrique (120),
- une deuxième partie de la couche de passivation diélectrique (120) recouvre latéralement la grille (118), et
- la deuxième électrode (116) recouvre latéralement la deuxième partie de la couche de passivation diélectrique (120),
ou dans lequel :
- la portion métallique (154) entoure latéralement au moins en partie la première électrode (112), la première portion de semi-conducteur (106) et au moins une partie de la deuxième portion de semi-conducteur (108), et
- la deuxième électrode (116) recouvre latéralement la portion métallique (154).

3. Dispositif optoélectronique (100) selon l'une des revendications précédentes, comportant :
- plusieurs structures mesa (124),
- plusieurs couches de passivation diélectriques (120) recouvrant chacune au moins une partie des flancs latéraux d'au moins une partie de la première (106) et/ou de la deuxième (108) portion de semi-conducteur et d'au moins une partie de la zone de charge d'espace d'une des structures mesa (124) et plusieurs grilles (118) électriquement conductrices telles que chaque couche de passivation diélectrique (120) est disposée entre l'une des grilles (118) et ladite au moins une partie de la première et/ou de la deuxième portion de semi-conducteur d'une des structures mesa (124) et entre l'une des grilles (118) et ladite au moins une partie de la zone de charge d'espace d'une des structures mesa (124), ou plusieurs portions métalliques (154) recouvrant chacune au moins une partie des flancs latéraux d'au moins une partie de la première (106) et/ou de la deuxième (108) portion de semi-conducteur et d'au moins une partie de la zone de charge d'espace d'une des structures mesa (124),
dans lequel la deuxième électrode (116) est reliée électriquement à la deuxième portion de semi-conducteur (108) de chacune des structures mesa (124), et dans lequel les faces supérieures d'au moins la première électrode (112) de chacune des structures mesa (124) et de la deuxième électrode (116) forment la surface continue sensiblement plane (122).

4. Dispositif optoélectronique (100) selon la revendication 3, dans lequel :
- chacune des structures mesa (124) est entourée latéralement au moins en partie par une première partie d'une des couches de passivation diélectriques (120),
- chacune des grilles (118) recouvre latéralement la première partie d'une des couches de passivation diélectriques (120),
- une deuxième partie de chacune des couches de passivation diélectriques (120) recouvre latéralement l'une des grilles (118), et
- la deuxième électrode (116) recouvre latéralement les deuxièmes parties des couches de passivation diélectriques (120),
ou dans lequel :
- chacune des structures mesa (124) est entourée latéralement au moins en partie par une des portions métalliques (154), et
- la deuxième électrode (116) recouvre latéralement les portions métalliques (154).

5. Dispositif optoélectronique (100) selon la revendication 1, dans lequel :
- la grille (118) comporte au moins une portion d'au moins un matériau électriquement conducteur s'étendant dans la structure mesa (124), ou la portion métallique (154) s'étend dans la structure mesa (124), et
- la deuxième électrode (116) est disposée autour de la structure mesa (124).

6. Dispositif optoélectronique (100) selon la revendication 1, comportant plusieurs structures mesa (124), et dans lequel :
- la grille (118) comporte plusieurs portions d'au moins un matériau électriquement conducteur s'étendant dans une ou plusieurs des structures mesa (124), ou plusieurs portions métalliques (154) s'étendent dans une ou plusieurs des structures mesa (124), et
- la deuxième électrode (116) est disposée autour de la ou de chacune des structures mesa (124).

7. Dispositif optoélectronique (100) selon l'une des revendications précédentes, comportant en outre un contact électrique (128) disposé à côté de la structure mesa (124) et de la deuxième électrode (116), et auquel la grille (118) ou la portion métallique (154) est reliée électriquement.

8. Dispositif optoélectronique (100) selon l'une des revendications précédentes, dans lequel la surface continue sensiblement plane (122) est formée en outre par une face supérieure de la grille (118) ou de la portion métallique (154), et/ou par une face supérieure de la couche de passivation diélectrique (120).

9. Dispositif optoélectronique (100) selon l'une des revendications 1 à 7, dans lequel la couche de passivation diélectrique (120) recouvre une face supérieure de la grille (118).

10. Dispositif optoélectronique (100) selon l'une des revendications précédentes, comportant en outre au moins une couche tampon (110) comportant un semi-conducteur dopé selon le même type de conductivité que la deuxième portion de semi-conducteur (108) et sur laquelle sont disposées la deuxième portion de semi-conducteur (108) et la deuxième électrode (116) l'une à côté de l'autre.

11. Dispositif optoélectronique (100) selon l'une des revendications précédentes, comportant en outre une deuxième couche de semi-conducteur dopée (111) comportant une face supérieure structurée dont une première partie saillante forme la deuxième portion de semi-conducteur (108), et dans laquelle la deuxième électrode (116) est disposée sur au moins une deuxième partie de la deuxième couche de semi-conducteur dopée (111) formant un creux de la face structurée de la deuxième couche de semi-conducteur dopée (111).

12. Dispositif optoélectronique (100) selon l'une des revendications 1 à 10, dans lequel une première partie (123) de la deuxième portion de semi-conducteur (108) disposée entre une deuxième partie (125) de la deuxième portion de semi-conducteur (108) et la première portion de semi-conducteur (106) forme un décrochement par rapport à la deuxième partie (125) de la deuxième portion de semi-conducteur (108), et dans lequel la deuxième électrode (116) est reliée électriquement à la deuxième portion de semi-conducteur (108) au niveau d'une face supérieure (127) de la deuxième partie (125) de la deuxième portion de semi-conducteur (108).

13. Dispositif électronique (1000) comportant un ou plusieurs dispositifs optoélectroniques (100) selon l'une des revendications précédentes correspondant à une ou plusieurs diodes électroluminescentes et/ou une ou plusieurs photodiodes.

14. Procédé d'émission lumineuse à partir d'un dispositif optoélectronique (100) selon l'une des revendications 1 à 12, comportant la mise en œuvre d'une polarisation du dispositif optoélectronique (100) par l'application d'une tension électrique entre la première électrode (112) et la deuxième électrode (116) du dispositif optoélectronique (100), et :
- l'application d'une différence de potentiels électriques entre la grille (118) ou la portion métallique (154), et l'électrode (112) reliée électriquement à la portion de semi-conducteur dopée p (106) telle que le potentiel électrique appliqué sur la grille (118) ou la portion métallique (154) est inférieur ou égal au potentiel électrique appliqué sur l'électrode (112) reliée électriquement à la portions de semi-conducteur dopée p (106), ou
- l'application d'une différence de potentiels électriques entre la grille (118) ou la portion métallique (154), et l'électrode (112) reliée électriquement à la portions de semi-conducteur dopée n (106) telle que le potentiel électrique appliqué sur la grille (118) ou la portion métallique (154) est supérieur ou égal au potentiel électrique appliqué sur l'électrode (112) reliée électriquement à la portion de semi-conducteur dopée n (106).

15. Procédé de conversion photoélectrique à partir d'un dispositif optoélectronique (100) selon l'une des revendications 1 à 12, comportant :
- l'application d'une différence de potentiels électriques entre la grille (118) ou la portion métallique (154) et l'électrode (112) reliée électriquement à la portion de semi-conducteur dopée p (106) telle que le potentiel électrique appliqué sur la grille (118) ou la portion métallique (154) est inférieur ou égal au potentiel électrique appliqué sur l'électrode (112) reliée électriquement à la portion de semi-conducteur dopée p (106), ou
- l'application d'une différence de potentiels électriques entre la grille (118) ou la portion métallique (154) et l'électrode (112) reliée électriquement à la portion de semi-conducteur dopée n (106) telle que le potentiel électrique appliqué sur la grille (118) ou la portion métallique (154) est supérieur ou égal au potentiel électrique appliqué sur l'électrode (112) reliée électriquement à la portion de semi-conducteur dopée n (106).

16. Procédé de réalisation d'un dispositif optoélectronique (100) comportant au moins les étapes de :
- réalisation d'un empilement de couches comprenant au moins une première couche de semi-conducteur (115) disposée entre une deuxième couche de semi-conducteur (111) et une couche électriquement conductrice, l'une (115) de la première et de la deuxième couche de semi-conducteur étant dopée p et l'autre (111) de la première et de la deuxième couche de semi-conducteur étant dopée n,
- gravure de l'empilement de couches, réalisant au moins une structure mesa (124) comprenant une première (106) et une deuxième (108) portions de semi-conducteur formant une jonction p-n et une première électrode (112) reliée électriquement à la première portion de semi-conducteur (106),
- réalisation d'un élément (118, 120, 154) apte à ioniser des dopants de la première (106) et/ou deuxième (108) portion de semi-conducteur via une génération d'un champ électrique dans la première (106) et/ou deuxième (108) portion de semi-conducteur et recouvrant au moins une partie des flancs latéraux d'au moins une partie de la première (106) et/ou de la deuxième (108) portion de semi-conducteur et d'au moins une partie d'une zone de charge d'espace formée par les première (106) et deuxième (108) portions de semi-conducteur,
- réalisation d'une deuxième électrode (116) reliée électriquement à la deuxième portion de semi-conducteur (108),
dans lequel au moins la réalisation de la deuxième électrode (116) comporte une étape de planarisation d'un matériau électriquement conducteur telle que des faces supérieures d'au moins la première électrode (112) et la deuxième électrode (116) forment une surface continue sensiblement plane (122), et dans lequel l'élément apte à ioniser des dopants de la première (106) et/ou deuxième (108) portion de semi-conducteur comporte :
- au moins une couche de passivation diélectrique (120) recouvrant ladite au moins une partie des flancs latéraux d'au moins une partie de la première (106) et/ou de la deuxième (108) portion de semi-conducteur et d'au moins une partie de la zone de charge d'espace, et au moins une grille (118) électriquement conductrice telle que la couche de passivation diélectrique (120) soit disposée entre la grille (118) et ladite au moins une partie de la première (106) et/ou de la deuxième (108) portion de semi-conducteur et entre la grille (118) et ladite au moins une partie de la zone de charge d'espace, ou
- au moins une portion métallique (154) recouvrant ladite au moins une partie des flancs latéraux d'au moins une partie de la première (106) et/ou de la deuxième (108) portion de semi-conducteur et d'au moins une partie de la zone de charge d'espace et formant un contact Schottky avec ladite au moins une partie de la première (106) et/ou de la deuxième (108) portion de semi-conducteur et avec ladite au moins une partie de la zone de charge d'espace
et dans lequel la première portion de semi-conducteur (106) est dopée p et comporte au moins un semi-conducteur dont une énergie d'activation des accepteurs est supérieure ou égale à environ 200 meV, ou dans lequel la première portion de semi-conducteur (106) est dopée n et comporte au moins un semi-conducteur dont une énergie d'activation des donneurs est supérieure ou égale à environ 200 meV.

## Patentansprüche

1. Optoelektronische Vorrichtung (100), umfassend mindestens eine Mesa-Struktur (124), mindestens umfassend:
- einen ersten (106) und einen zweiten (108) Halbleiterabschnitt, wobei der eine p-dotiert und der andere n-dotiert ist, die gemeinsam einen p-n-Übergang bilden,
- eine erste Elektrode (112), die elektrisch mit dem ersten Halbleiterabschnitt (106) verbunden ist, die zwischen dem zweiten Halbleiterabschnitt (108) und der ersten Elektrode (112) angeordnet ist,
wobei die optoelektronische Vorrichtung (100) ferner mindestens umfasst:
- eine zweite Elektrode (116), die elektrisch mit dem zweiten Halbleiterabschnitt (108) verbunden ist,
- ein Element (118, 120, 154), das geeignet ist, Dotierungsmittel des ersten (106) und/oder zweiten (108) Halbleiterabschnitts über eine Erzeugung eines elektrischen Feldes in dem ersten (106) und/oder dem zweiten (108) Halbleiterabschnitt zu ionisieren, und das mindestens einen Teil der Seiten mindestens eines Teils des ersten (106) und/oder des zweiten (108) Halbleiterabschnitts und mindestens einen Teil einer Raumladungszone, die von den ersten (106) und zweiten (108) Halbleiterabschnitten gebildet ist, abdeckt,
wobei Oberseiten mindestens der ersten Elektrode (112) und der zweiten Elektrode (116) eine im Wesentlichen ebene durchgehende Fläche (122) bilden, und wobei das Element, das geeignet ist, Dotierungsmittel des ersten (106) und/oder zweiten (108) Halbleiterabschnitts zu ionisieren, umfasst:
- mindestens eine dielektrische Passivierungsschicht (120), die den mindestens einen Teil der Seiten mindestens eines Teils des ersten (106) und/oder des zweiten (108) Halbleiterabschnitts und mindestens eines Teils der Raumladungszone bedeckt, und mindestens ein elektrisch leitendes Gitter (118), so dass die dielektrische Passivierungsschicht (120) zwischen dem Gitter (118) und dem mindestens einen Teil des ersten (106) und/oder zweiten (108) Halbleiterabschnitts und zwischen dem Gitter (118) und dem mindestens einen Teil der Raumladungszone angeordnet ist, oder
- mindestens einen metallischen Abschnitt (154), der den mindestens einen Teil der Seiten mindestens eines Teils des ersten (106) und/oder des zweiten (108) Halbleiterabschnitts und mindestens einen Teil der Raumladungszone bedeckt und einen Schottky-Kontakt mit dem mindestens einen Teil des ersten (106) und/oder des zweiten (108) Halbleiterabschnitts und mit dem mindestens einen Teil der Raumladungszone bildet,
und wobei der erste Halbleiterabschnitt (106) p-dotiert ist und mindestens einen Halbleiterabschnitt umfasst, dessen Aktivierungsenergie der Akzeptoren größer oder gleich ungefähr 200 meV ist, ober wobei der erste Halbleiterabschnitt (106) n-dotiert ist und mindestens einen Halbleiter umfasst, dessen Aktivierungsenergie der Donoren größer oder gleich ungefähr 200 meV ist.

2. Optoelektronische Vorrichtung (100) nach Anspruch 1, bei der:
- ein erster Teil der dielektrischen Passivierungsschicht (120) seitlich zumindest teilweise die erste Elektrode (112), den ersten Halbleiterabschnitt (106) und mindestens einen Teil des zweiten Halbleiterabschnitts (108) umgibt,
- das Gitter (118) seitlich den ersten Teil der dielektrischen Passivierungsschicht (120) bedeckt,
- ein zweiter Teil der dielektrischen Passivierungsschicht (120) seitlich das Gitter (118) bedeckt, und
- die zweite Elektrode (116) seitlich den zweiten Teil der dielektrischen Passivierungsschicht (120) bedeckt,
oder bei der:
- der metallische Abschnitt (154) seitlich zumindest teilweise die erste Elektrode (112), den ersten Halbleiterabschnitt (106) und mindestens einen Teil des zweiten Halbleiterabschnitts (108) umgibt, und
- die zweite Elektrode (116) seitlich den metallischen Abschnitt (154) bedeckt.

3. Optoelektronische Vorrichtung (100) nach einem der vorhergehenden Ansprüche, umfassend:
- mehrere Mesa-Strukturen (124),
- mehrere dielektrische Passivierungsschichten (120), die jeweils mindestens einen Teil der Seiten mindestens eines Teils des ersten (106) und/oder des zweiten (108) Halbleiterabschnitts und mindestens einen Teil der Raumladungszone einer der Mesa-Strukturen (124) bedecken, und mehrere elektrisch leitende Gitter (118), so dass die dielektrische Passivierungsschicht (120) zwischen einem der Gitter (118) und dem mindestens einen Teil des ersten und/oder zweiten Halbleiterabschnitts einer der Mesa-Strukturen (124) und zwischen einem der Gitter (118) und dem mindestens einen Teil der Raumladungszone einer der Mesa-Strukturen (124) angeordnet ist, oder mehrere metallische Abschnitte (154), die jeweils mindestens einen Teil der Seiten mindestens eines Teils des ersten (106) und/oder des zweiten (108) Halbleiterabschnitts und mindestens einen Teil der Raumladungszone einer der Mesa-Strukturen (124) bedecken,
wobei die zweite Elektrode (116) elektrisch mit dem zweiten Halbleiterabschnitt (108) jeder der Mesa-Strukturen (124) verbunden ist, und wobei die Oberseiten mindestens der ersten Elektrode (112) jeder der Mesa-Strukturen (124) und der zweiten Elektrode (116) eine im Wesentlichen ebene durchgehende Fläche (122) bilden.

4. Optoelektronische Vorrichtung (100) nach Anspruch 3, bei der:
- jede der Mesa-Strukturen (124) seitlich zumindest teilweise von einem ersten Teil einer der dielektrischen Passivierungsschichten (120) umgeben ist,
- jedes der Gitter (118) seitlich den ersten Teil einer der dielektrischen Passivierungsschichten (120) bedeckt,
- ein zweiter Teil jeder der dielektrischen Passivierungsschichten (120) seitlich eines der Gitter (118) bedeckt, und
- die zweite Elektrode (116) seitlich die zweiten Teile der dielektrischen Passivierungsschichten (120) bedeckt,
oder bei der:
- jede der Mesa-Strukturen (124) seitlich zumindest teilweise von einem der metallischen Abschnitte (154) umgeben ist, und
- die zweite Elektrode (116) seitlich die metallischen Abschnitte (154) bedeckt.

5. Optoelektronische Vorrichtung (100) nach Anspruch 1, bei der:
- das Gitter (118) mindestens einen Abschnitt mindestens eines elektrisch leitenden Materials umfasst, der sich in der Mesa-Struktur (124) erstreckt, oder sich der metallische Abschnitt (154) in der Mesa-Struktur (124) erstreckt, und
- die zweite Elektrode (116) um die Mesa-Struktur (124) angeordnet ist.

6. Optoelektronische Vorrichtung (100) nach Anspruch 1, umfassend mehrere Mesa-Strukturen (124), und bei der:
- das Gitter (118) mehrere Abschnitte mindestens eines elektrisch leitenden Materials umfasst, die sich in einer oder mehreren Mesa-Strukturen (124) erstrecken, oder sich mehrere metallische Abschnitte (154) in einer oder mehreren der Mesa-Strukturen (124) erstrecken, und
- die zweite Elektrode (116) um die oder um jede der Mesa-Strukturen (124) angeordnet ist.

7. Optoelektronische Vorrichtung (100) nach einem der vorhergehenden Ansprüche, ferner umfassend einen elektrischen Kontakt (128), der neben der Mesa-Struktur (124) und der zweiten Elektrode (116) angeordnet ist, und mit dem das Gitter (118) oder der metallische Abschnitt (154) elektrisch verbunden ist.

8. Optoelektronische Vorrichtung (100) nach einem der vorhergehenden Ansprüche, bei der die im Wesentlichen ebene durchgehende Fläche (122) ferner von einer Oberseite des Gitters (118) oder des metallischen Abschnitts (154) und/oder von einer Oberseite der dielektrischen Passivierungsschicht (120) gebildet ist.

9. Optoelektronische Vorrichtung (100) nach einem der Ansprüche 1 bis 7, bei der die dielektrische Passivierungsschicht (120) eine Oberseite des Gitters (118) bedeckt.

10. Optoelektronische Vorrichtung (100) nach einem der vorhergehenden Ansprüche, ferner umfassend mindestens eine Pufferschicht (110), umfassend einen Halbleiter, der nach demselben Konduktivitätstyp wie der zweite Halbleiterabschnitt (108) dotiert ist, und auf der der zweite Halbleiterabschnitt (108) und die zweite Elektrode (116) nebeneinander angeordnet sind.

11. Optoelektronische Vorrichtung (100) nach einem der vorhergehenden Ansprüche, ferner umfassend eine zweite dotierte Halbleiterschicht (111), umfassend eine strukturierte Oberseite, wobei ein erster vorspringender Teil derselben den zweiten Halbleiterabschnitt (108) bildet, und bei der die zweite Elektrode (116) auf mindestens einem zweiten Teil der zweiten dotierten Halbleiterschicht (111) angeordnet ist, wobei ein Hohlraum der strukturierten Seite der zweiten dotierten Halbleiterschicht (111) gebildet wird.

12. Optoelektronische Vorrichtung (100) nach einem der Ansprüche 1 bis 10, bei der ein erster Teil (123) des zweiten Halbleiterabschnitts (108), der zwischen einem zweiten Teil (125) des zweiten Halbleiterabschnitts (108) und dem ersten Halbleiterabschnitt (106) angeordnet ist, einen Absatz zum zweiten Teil (125) des zweiten Halbleiterabschnitts (108) bildet, und bei der die zweite Elektrode (116) elektrisch mit dem zweiten Halbleiterabschnitt (108) im Bereich einer Oberseite (127) des zweiten Teils (125) des zweiten Halbleiterabschnitts (108) verbunden ist.

13. Elektronische Vorrichtung (1000), umfassend eine oder mehrere optoelektronische Vorrichtungen (100) nach einem der vorhergehenden Ansprüche, die einer oder mehreren Leuchtdioden und/oder einer oder mehreren Fotodioden entsprechen.

14. Verfahren zur Lichtemission von einer optoelektronischen Vorrichtung (100) nach einem der Ansprüche 1 bis 12, umfassend den Einsatz einer Polarisierung der optoelektronischen Vorrichtung (100) durch das Anlegen einer elektrischen Spannung zwischen der ersten Elektrode (112) und der zweiten Elektrode (116) der optoelektronischen Vorrichtung (100), und
- das Anlegen eines elektrischen Potentialunterschieds zwischen dem Gitter (118) oder dem metallischen Abschnitt (154) und der Elektrode (112), die elektrisch mit dem p-dotierten Halbleiterabschnitt (106) verbunden ist, so dass das an das Gitter (118) oder den metallischen Abschnitt (154) angelegte elektrische Potential kleiner oder gleich dem elektrischen Potential ist, das an die Elektrode (112) angelegt wird, die elektrisch mit dem p-dotierten Halbleiterabschnitt (106) verbunden ist, oder
- das Anlegen eines elektrischen Potentialunterschieds zwischen dem Gitter (118) oder dem metallischen Abschnitt (154) und der Elektrode (112), die elektrisch mit dem n-dotierten Halbleiterabschnitt (106) verbunden ist, so dass das an das Gitter (118) oder den metallischen Abschnitt (154) angelegte elektrische Potential größer oder gleich dem elektrischen Potential ist, das an die Elektrode (112) angelegt wird, die elektrisch mit dem n-dotierten Halbleiterabschnitt (106) verbunden ist.

15. Fotoelektrisches Umwandlungsverfahren ausgehend von einer optoelektronischen Vorrichtung (100) nach einem der Ansprüche 1 bis 12, umfassend:
- das Anlegen eines elektrischen Potentialunterschieds zwischen dem Gitter (118) oder dem metallischen Abschnitt (154) und der Elektrode (112), die elektrisch mit dem p-dotierten Halbleiterabschnitt (106) verbunden ist, so dass das an das Gitter (118) oder den metallischen Abschnitt (154) angelegte elektrische Potential kleiner oder gleich dem elektrischen Potential ist, das an die Elektrode (112) angelegt wird, die elektrisch mit dem p-dotierten Halbleiterabschnitt (106) verbunden ist, oder
- das Anlegen eines elektrischen Potentialunterschieds zwischen dem Gitter (118) oder dem metallischen Abschnitt (154) und der Elektrode (112), die elektrisch mit dem n-dotierten Halbleiterabschnitt (106) verbunden ist, so dass das an das Gitter (118) oder den metallischen Abschnitt (154) angelegte elektrische Potential größer oder gleich dem elektrischen Potential ist, das an die Elektrode (112) angelegt wird, die elektrisch mit dem n-dotierten Halbleiterabschnitt (106) verbunden ist.

16. Verfahren zur Herstellung einer optoelektronischen Vorrichtung (100) umfassend mindestens die folgenden Schritte:
- Herstellung eines Stapels von Schichten, umfassend mindestens eine erste Halbleiterschicht (115), die zwischen einer zweiten Halbleiterschicht (111) und einer elektrisch leitenden Schicht angeordnet ist, wobei eine (115) von der ersten und der zweiten Halbleiterschicht p-dotiert ist, und die andere (111) von der ersten und der zweiten Halbleiterschicht n-dotiert ist,
- Gravur des Stapels von Schichten, wobei mindestens eine Mesa-Struktur (124) hergestellt wird, umfassend einen ersten (106) und einen zweiten (108) Halbleiterabschnitt, die einen p-n-Übergang bilden, und eine erste Elektrode (112), die elektrisch mit dem ersten Halbleiterabschnitt (106) verbunden ist,
- Herstellung eines Elements (118, 120, 154), das geeignet ist, Dotierungsmittel des ersten (106) und/oder zweiten (108) Halbleiterabschnitts über eine Erzeugung eines elektrischen Feldes in dem ersten (106) und/oder dem zweiten (108) Halbleiterabschnitt zu ionisieren, und das mindestens einen Teil der Seiten mindestens eines Teils des ersten (106) und/oder des zweiten (108) Halbleiterabschnitts und mindestens einen Teil einer Raumladungszone, die von den ersten (106) und zweiten (108) Halbleiterabschnitten gebildet ist, abdeckt,
- Herstellung einer zweiten Elektrode (116), die elektrisch mit dem zweiten Halbleiterabschnitt (108) verbunden ist,
wobei zumindest die Herstellung der zweiten Elektrode (116) einen Schritt der Planarisierung eines elektrisch leitenden Materials umfasst, so dass Oberseiten mindestens der ersten Elektrode (112) und die zweite Elektrode (116) eine im Wesentlichen ebene durchgehende Fläche (122) bilden, und wobei das Element, das geeignet ist, Dotierungsmittel des ersten (106) und/oder zweiten (108) Halbleiterabschnitts zu ionisieren, umfasst:
- mindestens eine dielektrische Passivierungsschicht (120), die den mindestens einen Teil der Seiten mindestens eines Teils des ersten (106) und/oder des zweiten (108) Halbleiterabschnitts und mindestens eines Teils der Raumladungszone bedeckt, und mindestens ein elektrisch leitendes Gitter (118), so dass die dielektrische Passivierungsschicht (120) zwischen dem Gitter (118) und dem mindestens einen Teil des ersten (106) und/oder des zweiten (108) Halbleiterabschnitts und zwischen dem Gitter (118) und dem mindestens einen Teil der Raumladungszone angeordnet ist, oder
- mindestens einen metallischen Abschnitt (154), der den mindestens einen Teil der Seiten mindestens eines Teils des ersten (106) und/oder des zweiten (108) Halbleiterabschnitts und mindestens einen Teil der Raumladungszone bedeckt und einen Schottky-Kontakt mit dem mindestens einen Teil des ersten (106) und/oder des zweiten (108) Halbleiterabschnitts und mit dem mindestens einen Teil der Raumladungszone bildet,
und wobei der erste Halbleiterabschnitt (106) p-dotiert ist und mindestens einen Halbleiterabschnitt umfasst, dessen Aktivierungsenergie der Akzeptoren größer oder gleich ungefähr 200 meV ist, oder wobei der erste Halbleiterabschnitt (106) n-dotiert ist und mindestens einen Halbleiter umfasst, dessen Aktivierungsenergie der Donoren größer oder gleich ungefähr 200 meV ist.

## Claims

1. Optoelectronic device (100) having at least one mesa structure (124) including at least:
- a first (106) and a second (108) semiconductor portions, one being p-doped and the other being n-doped, and forming together a p-n junction,
- a first electrode (112) electrically connected to the first semiconductor portion (106) which is arranged between the second semiconductor portion (108) and the first electrode (112),
the optoelectronic device (100) further comprising at least:
- a second electrode (116) electrically connected to the second semiconductor portion (108),
- an element (118, 120, 154) able to ionize dopants of the first (106) and/or second (108) semiconductor portion through generating an electric field in the first (106) and/or second (108) semiconductor portion and overlaying at least one part of the side flanks of at least one part of the first (106) and/or second (108) semiconductor portion and of at least one part of a space charge zone formed by the first (106) and second (108) semiconductor portions,
and wherein upper faces of at least the first electrode (112) and of the second electrode (116) form a substantially planar continuous surface (122), and wherein the element able to ionize dopants of the first (106) and/or second (108) semiconductor portion comprises:
- at least one dielectric passivation layer (120) overlaying said at least one part of the side flanks of at least one part of the first (106) and/or second (108) semiconductor portion and of at least one part of the space charge zone, and at least one electrically conductive gate (118) such that the dielectric passivation layer (120) is arranged between the gate (118) and said at least one part of the first (106) and/or second (108) semiconductor portion and between the gate (118) and said at least one part of the space charge zone, or
- at least one metallic portion (154) overlaying said at least one part of the side flanks of at least one part of the first (106) and/or second (108) semiconductor portion and of at least one part of the space charge zone and forming a Schottky contact with said at least one part of the first (106) and/or second (108) semiconductor portion and with at least one part of the space charge zone,
and wherein the first (106) semiconductor portion is p-doped and comprises at least one semiconductor an acceptor activation energy of which is higher than or equal to around 200 meV, or wherein the first (106) semiconductor portion is n-doped and comprises at least one semiconductor a donor activation energy of which is higher than or equal to around 200 meV.

2. Optoelectronic device (100) according to claim 1, wherein:
- a first part of the dielectric passivation layer (120) laterally surrounds at least partly the first electrode (112), the first semiconductor portion (106) and at least one part of the second semiconductor portion (108),
- the gate (118) laterally overlays the first part of the dielectric passivation layer (120),
- a second part of the dielectric passivation layer (120) laterally overlays the gate (118), and
- the second electrode (116) laterally overlays the second part of the dielectric passivation layer (120),
or wherein:
- the metallic portion (154) laterally surrounds at least partly the first electrode (112), the first semiconductor portion (106) and at least one part of the second semiconductor portion (108), and
- the second electrode (116) laterally overlays the metallic portion (154).

3. Optoelectronic device (100) according to one of previous claims, comprising:
- several mesa structures (124),
- several dielectric passivation layers (120) each overlaying at least one part of the side flanks of at least one part of the first (106) and/or second (108) semiconductor portion and of at least one part of the space charge zone of one of the mesa structures (124) and several electrically conductive gates (118) such that each dielectric passivation layer (120) is arranged between one of the gates (118) and said at least one part of the first and/or second semiconductor portion of one of the mesa structures (124) and between one of the gates (118) and said at least one part of the space charge zone of one of the mesa structures (124), or several metallic portions (154) each overlaying at least one part of the side flanks of at least one part of the first (106) and/or second (108) semiconductor portion and of at least one part of a space charge zone of one of the mesa structures (124),
wherein the second electrode (116) is electrically connected to the second semiconductor portion (108) of each mesa structure (124), and wherein the upper faces of at least the first electrode (112) of each mesa structure (124) and of the second electrode (116) form the substantially planar continuous surface (122).

4. Optoelectronic device (100) according to claim 3, wherein:
- each mesa structure (124) is at least partly laterally surrounded by a first part of one of the dielectric passivation layers (120),
- each gate (118) laterally overlays the first part of one of the dielectric passivation layers (120),
- a second part of each dielectric passivation layer (120) laterally overlays one of the gates (118), and
- the second electrode (116) laterally overlays the second parts of the dielectric passivation layers (120),
or wherein:
- each mesa structure (124) is at least partly laterally surrounded by one of the metallic portions (154), and
- the second electrode (116) laterally overlays the metallic portions (154).

5. Optoelectronic device according to claim 1, wherein:
- the gate (118) comprises at least one portion of at least one electrically conductive material extending in the mesa structure (124), or the metallic portion (154) extends in the mesa structure (124), and
- the second electrode (116) is arranged around the mesa structure (124).

6. Optoelectronic device (100) according to claim 1, comprising several mesa structures (124), and wherein:
- the gate (118) comprises several portions of at least one electrically conductive material extending in one or several of the mesa structures (124), or several metallic portions (154) extend in one or several of the mesa structures (124), and
- the second electrode (116) is arranged around the or each mesa structure (124).

7. Optoelectronic device (100) according to one of the preceding claims, further comprising an electrical contact (128) arranged next to the mesa structure (124) and next to the second electrode (116), and to which the gate (118) or the metallic portion (154) is electrically connected.

8. Optoelectronic device (100) according to one of the preceding claims, wherein the substantially planar continuous surface (122) is further formed by upper faces of the gate (118) or the metallic portion (154), and/or by an upper face of the dielectric passivation layer (120).

9. Optoelectronic device (100) according to one of claims 1 to 7, wherein the dielectric passivation layer (120) overlays an upper face of the gate (118).

10. Optoelectronic device (100) according to one of the preceding claims, further comprising at least one buffer layer (110) comprising a semiconductor doped according to the same conductivity type as the second semiconductor portion (108) and on which the second semiconductor portion (108) and the second electrode (116) are arranged next to each other.

11. Optoelectronic device (100) according to one of the preceding claims, further comprising a second doped semiconductor layer (111) comprising a structured upper face, a first protruding part of which forms the second semiconductor portion (108), and wherein the second electrode (116) is arranged on at least a second part of the second doped semiconductor layer (111) forming a hollow of the structured face of the second doped semiconductor layer (111).

12. Optoelectronic device (100) according to one of claims 1 to 10, wherein a first part (123) of the second semiconductor portion (108) arranged between a second part (125) of the second semiconductor portion (108) and the first semiconductor portion (106) forms a recess regarding the second part (125) of the second semiconductor portion (108), and wherein the second electrode (116) is electrically connected to the second semiconductor portion (108) at an upper face (127) of the second part (125) of the second semiconductor portion (108).

13. Electronic device (1000) comprising one or several optoelectronic devices (100) according to one of the preceding claims corresponding to one or several light emitting diodes and/or one or several photodiodes.

14. Method of light emission from an optoelectronic device (100) according to one of claims 1 to 12, comprising implementing a polarization of the optoelectronic device (100) by applying an electric voltage between the first electrode (112) and the second electrode (116) of the optoelectronic device (100), and:
- applying an electric potential difference between the gate (118) or the metallic portion (154) and the electrode (112) electrically connected to the p-doped semiconductor portion (106) such that the electric potential applied to the gate (118) or the metallic portion (154) is equal to or lower than the electric potential applied to the electrode (112) electrically connected to the p-doped semiconductor portion (106), or
- applying an electric potential difference between the gate (118) or the metallic portion (154) and the electrode (112) electrically connected to the n-doped semiconductor portion (106) such that the electric potential applied to the gate (118) or the metallic portion (154) is equal to or higher than the electric potential applied to the electrode (112) electrically connected to the n-doped semiconductor portion (106).

15. Method of photoelectric conversion from an optoelectronic device (100) according to one of claims 1 to 12, comprising:
- applying an electric potential difference between the gate (118) or the metallic portion (154) and the electrode (112) electrically connected to the p-doped semiconductor portion (106) such that the electric potential applied to the gate (118) or metallic portion (154) is equal to or lowerthan the electric potential applied to the electrode (112) electrically connected to the p-doped semiconductor portion (106), or
- applying an electric potential difference between the gate (118) or the metallic portion (154) and the electrode (112) electrically connected to the n-doped semiconductor portion (106) such that the electric potential applied to the gate (118) or the metallic portion (154) is equal to or higher than the electric potential applied to the electrode (112) electrically connected to the n-doped semiconductor portion (106).

16. Method for making an optoelectronic device (100) comprising at least the steps of:
- making a layer stack including at least one first semiconductor layer (115) arranged between a second semiconductor layer (111) and an electrically conductive layer, one (115) of the first and second semiconductor layers being p-doped and the other (111) of the first and second semiconductor layers being n-doped,
- etching the layer stack, making at least one mesa structure (124) including a first (106) and a second (108) semiconductor portions forming a p-n junction and a first electrode (112) electrically connected to the first semiconductor portion (106),
- making an element (118, 120, 154) able to ionize dopants of the first (106) and/or second (108) semiconductor portion through generating an electric field in the first (106) and/or second (108) semiconductor portion and overlaying at least one part of the side flanks of at least one part of the first (106) and/or second (108) semiconductor portion and of at least one part of a space charge zone formed by the first (106) and second (108) semiconductor portions,
- making a second electrode (116) electrically connected to the second semiconductor portion (108),
and wherein at least making the second electrode (116) comprises a step of planarizing an electrically conductive material such that upper faces of at least the first electrode (112) and of the second electrode (116) form a substantially planar continuous surface (122) and wherein the element able to ionize dopants of the first (106) and/or second (108) semiconductor portion comprises:
- at least one dielectric passivation layer (120) overlaying said at least one part of the side flanks of at least one part of the first (106) and/or second (108) semiconductor portion and of at least one part of the space charge zone, and at least one electrically conductive gate (118) such that the dielectric passivation layer (120) is arranged between the gate (118) and said at least one part of the first (106) and/or second (108) semiconductor portion and between the gate (118) and said at least one part of the space charge zone, or
- at least one metallic portion (154) overlaying said at least one part of the side flanks of at least one part of the first (106) and/or second (108) semiconductor portion and of at least one part of the space charge zone and forming a Schottky contact with said at least one part of the first (106) and/or second (108) semiconductor portion and with at least one part of the space charge zone,
and wherein the first (106) semiconductor portion is p-doped and comprises at least one semiconductor an acceptor activation energy of which is higher than or equal to around 200 meV, or wherein the first (106) semiconductor portion is n-doped and comprises at least one semiconductor a donor activation energy of which is higher than or equal to around 200 meV.
